# EUROPEAN PATENT SPECIFICATION

(11) **EP 4 421 851 B1**
(45) Date of publication and mention of the grant of the patent: **22.04.2026**
(21) Application number: 22886933.5
(22) Date of filing: 24.10.2022
(51) Int. Cl.: H10K 85/10, H10K 10/46

(54) **RESIN, INSULATING FILM AND ORGANIC FIELD EFFECT TRANSISTOR COMPRISING SAME**
HARZ, ISOLATIONSFILM UND ORGANISCHER FELDEFFEKTTRANSISTOR DAMIT
RÉSINE, FILM ISOLANT ET TRANSISTOR À EFFET DE CHAMP ORGANIQUE LE COMPRENANT

(30) Priority: 27.10.2021 JP 2021175454
(43) Date of publication of application: 28.08.2024
(73) Proprietor: Tosoh Corporation, Yamaguchi 746-8501 (JP)
(72) Inventor: IIJIMA, Yuta, Yokkaichi-Shi, Mie 510-8540 (JP); YUMINO, Shohei, Yokkaichi-Shi, Mie 510-8540 (JP); FUKUDA, Takashi, Yokkaichi-Shi, Mie 510-8540 (JP); SHIWAKU, Rei, Yokkaichi-Shi, Mie 510-8540 (JP); OKU, Shinya, Yokkaichi-Shi, Mie 510-8540 (JP)
(74) Representative: Novagraaf International SA
(86) International application number: PCT/JP2022/039467
(87) International publication number: WO 2023/074606

(56) References cited:
- JP-A- 2010 511 094
- JP-A- 2018 018 928
- JP-A- 2019 178 191
- JP-A- 2021 050 298
- JP-A- 2021 050 298
- US-A1- 2021 135 115

## Description

### TECHNICAL FIELD

The present disclosure relates to a resin for forming gate insulating film layers suitable for organic field-effect transistor devices with high bias stress resistance.

### BACKGROUND ART

Organic field-effect transistor devices, which can be manufactured through film-forming methods including application or printing of organic material-containing solutions, have attracted attention for their potential to be manufactured in a large number on a large-area substrate at a low cost.

As a polymer dielectric layer (insulating film layer) used in organic field effect transistor devices, a technique using a photocrosslinkable polymer in which a compound having a photocrosslinkable group is introduced into an aromatic vinyl polymer such as polystyrene or poly-α-methylstyrene by a Friedel-Crafts acylation reaction has been disclosed (see, for example, Patent Document 1).

In recent years, such polymer dielectric layers have been required to have higher bias stress resistance for reliability and stability of organic field-effect transistor devices. It is generally known that under application of a constant bias voltage for a long time, organic field-effect transistor devices will change their threshold voltage. Such bias stress-induced changes in threshold voltage should preferably be at most 2 V. Such changes may be attributed to various causes including environmental factors, such as oxidation by the air and water from the air, and other factors, such as organic semiconductor crystal structure and defects, among which one of the main factors may be carrier trapping, which is a phenomenon in which after being generated in semiconductor layers, carriers are trapped in polymer dielectric layers (insulating film layers) (see, for example, Non-Patent Document 1). Patent Documents 2 and 3 disclose organic field-effect transistors that use polymer resins.

### Citation List

### Patent Document

Patent Document 1: Japanese Unexamined Patent Application, Publication No. 2018-154814 Patent Document 2: JP 2021 050298 A
Patent Document 3: US 2021/135115 A1

### Non-Patent Document

Non-Patent Document 1: Advanced Materials, Vol. 26, p. 1660 (2014)

### DISCLOSURE OF THE INVENTION

### Problems to be Solved by the Invention

As a result of research, the inventors have found that recent organic field-effect transistor devices have been required to have bias stress resistance higher than that of the organic field-effect transistor device having a gate insulating film layer of the resin disclosed in Patent Document 1.

It is an object of the present disclosure, which has been made in view of the problem described above, to provide a resin for forming gate insulating film layers suitable for organic field-effect transistor devices with high bias stress resistance.

### Means for Solving the Problems

As a result of intensive studies, the inventors have completed the present disclosure based on findings that by deepening the HOMO level of the resin (insulating film layer),the energy barrier when carriers generated in the organic semiconductor layer are captured by the resin increases, as a result, carrier traps are suppressed, which is effective in improving mobility and bias stress resistance, and certain resins have excellent mobility and bias stress resistance required for insulating films.

Specifically, the above mentioned problems are solved by the invention as disclosed below.

[1] A resin including: a repeating unit represented by Formula (1); and a repeating unit represented by Formula (2), the repeating unit represented by Formula (2) having a HOMO level of -6.4 eV or less, the resin containing 20 mol% or more of the repeating unit represented by Formula (2) based on the total moles of the repeating unit represented by Formula (1) and the repeating unit represented by Formula (2), 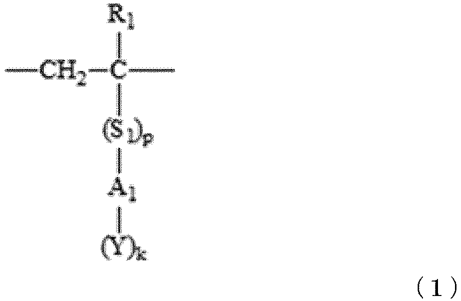
   wherein in Formula (1), R₁ represents a hydrogen atom or a C1-C6 alkyl group, S₁ represents -O- or -C(O)-, p represents 0 or 1, A₁ represents a C6-C19 aryl group, Y represents a halogen atom, a cyano group, a nitro group, a carboxyalkyl group, an alkyl ether group, an aryl ether group, a C1-C18 alkyl group, a fluoroalkyl group, or a cycloalkyl group, k represents an integer of 0 to (s-1), and s represents the number of carbon atoms in A₁, 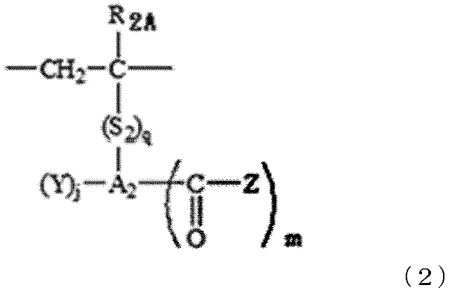
   wherein in Formula (2), R_{2A} represents a hydrogen atom or a C1-C6 alkyl group, S₂ represents -O- or -C(O)-, q represents 0 or 1, A₂ represents a C6-C19 aryl group, Y represents the same substituent as defined for Formula (1), j represents an integer of 0 to (r - 2), m represents an integer of 1 to (r - j - 1), r represents the number of carbon atoms in A₂, and Z represents at least one organic group selected from the group consisting of organic groups represented by Formulae (A) to (D) : 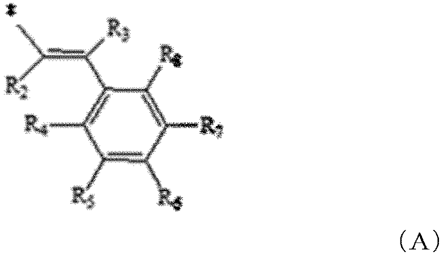 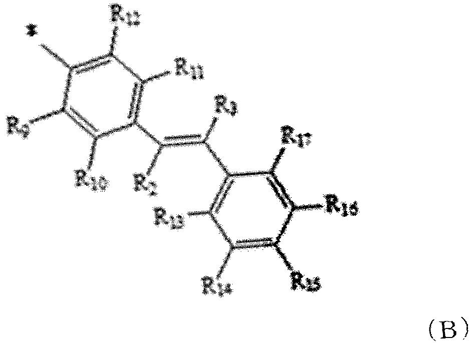 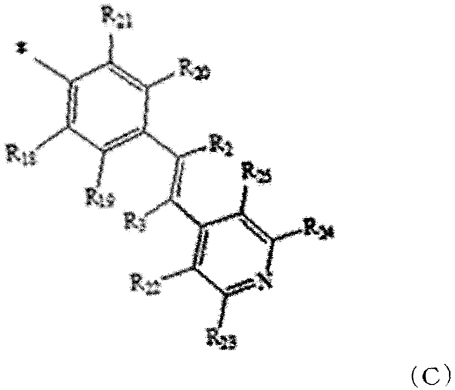 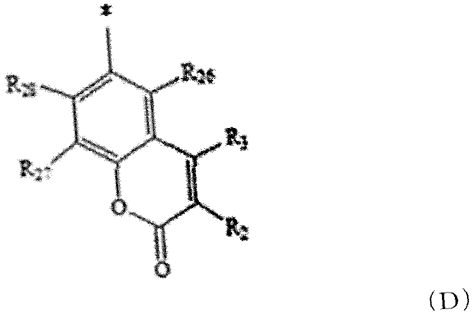
   wherein in Formulae (A) to (D), R₂ and R₃ each independently represent a hydrogen atom, a halogen atom, a C1-C6 alkyl group, an aryl group, or a carboxyalkyl group, R₄ to R₂₈ each independently represent a hydrogen atom, a halogen atom, a cyano group, a nitro group, a carboxyalkyl group, an alkyl ether group, an aryl ether group, a C1-C18 alkyl group, a fluoroalkyl group, or a cycloalkyl group, and * indicates a bond
      wherein the repeating unit represented by Formula (2) has at least one selected from the group consisting of a halogen atom, a cyano group, a nitro group, a carboxyalkyl group, and a fluoroalkyl group.
[2] An insulating film including a crosslinked product of the resin according to [1].
[3] An organic field effect transistor device comprising an organic semiconductor layer, the organic field effect transistor further comprising a source electrode and a drain electrode and a gate electrode laminated on a substrate with a gate insulating layer interposed between the gate electrode and the organic semiconductor layer, characterized in that the gate insulating layer is the insulating film according to [2].

### Effects of the Invention

The present disclosure provides a resin for forming gate insulating film layers suitable for organic field-effect transistor devices with high bias stress resistance.

### BRIEF DESCRIPTION OF THE DRAWINGS

FIG. 1 is a view of a cross-sectional shape of a bottom-gate bottom-contact (BGBC) type device;
FIG. 2 is a diagram showing a ¹H-NMR chart of resin 1 produced in Example 1;
FIG. 3 is a graph showing that an OFET device produced in Example 1 suffers from a minor change in transfer characteristics (Id-Vg) before and after continuous application of a gate voltage (Vg) of -30 V for 1 hour and thus has high bias stress resistance; and

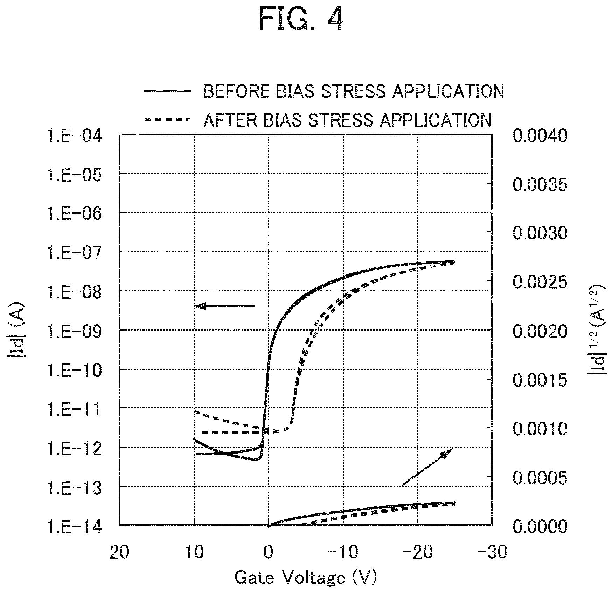

FIG. 4 is a graph showing that an OFET device produced in Comparative Example 1 suffers from a significant change in transfer characteristics (Id-Vg) before and after continuous application of a gate voltage (Vg) of -30 V for 1 hour.

### PREFERRED MODE FOR CARRYING OUT THE INVENTION

Hereinafter, the present claimed invention will be described in detail.

The resin of the present invention includes the repeating unit represented by Formula (1) and the repeating unit represented by Formula (2).

In Formula (1), R₁ represents a hydrogen atom or a C1-C6 alkyl group, and preferably represents a hydrogen atom.

Examples of the C1-C6 alkyl group for R₁ in Formula (1) include, but are not limited to, a methyl group, an ethyl group, an n-propyl group, an isopropyl group, and an n-butyl group.

In Formula (1), S₁ represents -O- or -C(O)-.

In Formula (1), p represents 0 or 1, and preferably represents 0.

In Formula (1), A₁ represents a C6-C19 aryl group.

Examples of the C6-C19 aryl group for A₁ in Formula (1) include, but are not limited to, a phenyl group, a naphthyl group, an anthryl group, and a biphenyl group, among which a phenyl group is preferred.

In Formula (1), Y represents a halogen atom, a cyano group, a nitro group, a carboxyalkyl group, an alkyl ether group, an aryl ether group, a C1-C18 alkyl group, a fluoroalkyl group, or a cycloalkyl group.

Examples of the halogen atom for Y in Formula (1) include, but are not limited to, a chlorine atom, a fluorine atom, and a bromine atom.

Examples of the carboxyalkyl group for Y in Formula (1) include, but are not limited to, a carboxymethyl group (-COOCH₃), a carboxyethyl group (-COOCH₂CH₃), and a carboxypropyl group (-COOCH₂CH₂CH₃).

Examples of the alkyl ether group for Y in Formula (1) include, but are not limited to, a methoxy group, an ethoxy group, an n-propoxy group, an isopropoxy group, and a butoxy group.

Examples of the aryl ether group for Y in Formula (1) include, but are not limited to, a phenoxy group, a p-methylphenoxy group, a p-ethylphenoxy group, and a p-methoxyphenoxy group.

Examples of the C1-C18 alkyl group for Y in Formula (1) include, but are not limited to, a methyl group, an ethyl group, an n-propyl group, an isopropyl group, and an n-butyl group.

Examples of the fluoroalkyl group for Y in Formula (1) include, but are not limited to, a 1,1,1-trifluoroethyl group, a 1,1,1,2,2-pentafluoropropyl group, a 1,1,1,2,2,3,3-heptafluorobutyl group, a trifluoromethyl group, and a pentafluoroethyl group.

Examples of the cycloalkyl group for Y in Formula (1) include, but are not limited to, a cyclobutyl group, a cyclopentyl group, and a cyclohexyl group.

In Formula (1), k represents an integer of 0 to (s-1), and preferably represents 0,
wherein s represents the number of carbon atoms in A₁.

In Formula (2), R_{2A} represents a hydrogen atom or a C1-C6 alkyl group, and preferably represents a hydrogen atom.

Examples of the C1-C6 alkyl group for R_{2A} in Formula (2) include, but are not limited to, a methyl group, an ethyl group, an n-propyl group, an isopropyl group, and an n-butyl group.

In Formula (2), S₂ represents -O- or -C(O)-.

In Formula (2), q represents 0 or 1, and preferably represents 0.

In Formula (2), A₂ represents a C6-C19 aryl group.

Examples of the C6-C19 aryl group for A₂ in Formula (2) include, but are not limited to, a phenyl group, a naphthyl group, an anthranil group, and a biphenyl group, among which a phenyl group is preferred.

In Formula (2), Y represents the same substituent as defined for Formula (1).

In Formula (2), m represents an integer of 1 to (r - j - 1), r represents the number of carbon atoms in A₂, and j represents an integer of 0 to (r - 2). m is preferably 1, and j is preferably 0.

In Formula (2), Z represents at least one organic group selected from the group consisting of organic groups represented by Formulae (A) to (D), and preferably represents an organic group represented by Formula (A).

In formulae (A) to (D), R₂ and R₃ each independently represent a hydrogen atom, a halogen atom, a C1-C6 alkyl group, an aryl group, or a carboxyalkyl group, preferably each independently represent a hydrogen atom, a halogen atom, or a C1-C6 alkyl group, and more preferably each independently represent a hydrogen atom; R₄ to R₂₈ each independently represent a hydrogen atom, a halogen atom, a cyano group, a nitro group, a carboxyalkyl group, an alkyl ether group, an aryl ether group, a C1-C18 alkyl group, a fluoroalkyl group, or a cycloalkyl group, preferably each independently represent a halogen atom, a cyano group, a nitro group, a carboxyalkyl group, or a fluoroalkyl group, and more preferably each independently represent a halogen atom, a nitro group, or a fluoroalkyl group.

Examples of the halogen atom for R₂ and R₃ in Formulae (A) to (D) include, but are not limited to, a chlorine atom, a fluorine atom, and a bromine atom.

Examples of the C1-C6 alkyl group for R₂ and R₃ in Formulae (A) to (D) include, but are not limited to, a methyl group, an ethyl group, an n-propyl group, an isopropyl group, and an n-butyl group.

Examples of the aryl group for R₂ and R₃ in Formulae (A) to (D) include, but are not limited to, a phenyl group, a naphthyl group, an anthryl group, and a biphenyl group.

Examples of the carboxyalkyl group for R₂ and R₃ in Formulae (A) to (D) include, but are not limited to, a carboxymethyl group (-COOCH₃), a carboxyethyl group (-COOCH₂CH₃), and a carboxypropyl group (-COOCH₂CH₂CH₃).

Examples of the halogen atom for R₄ to R₂₈ in Formulae (A) to (D) include, but are not limited to, a chlorine atom, a fluorine atom, and a bromine atom, among which a chlorine atom and a fluorine atom are preferred.

Examples of the carboxyalkyl group for R₄ to R₂₈ in Formulae (A) to (D) include, but are not limited to, a carboxymethyl group (-COOCH₃), a carboxyethyl group (-COOCH₂CH₃), and a carboxypropyl group (-COOCH₂CH₂CH₃).

Examples of the alkyl ether group for R₄ to R₂₈ in Formulae (A) to (D) include, but are not limited to, a methoxy group, an ethoxy group, an n-propoxy group, an isopropoxy group, and a butoxy group.

Examples of the aryl ether group for R₄ to R₂₈ in Formulae (A) to (D) include, but are not limited to, a phenoxy group, a p-methylphenoxy group, a p-ethylphenoxy group, and a p-methoxyphenoxy group.

Examples of the C1-C18 alkyl group for R₄ to R₂₈ in Formulae (A) to (D) include, but are not limited to, a methyl group, an ethyl group, an n-propyl group, an isopropyl group, an n-butyl group, an n-hexyl group, an n-decyl group, and an n-octadecyl group.

Examples of the fluoroalkyl group for R₄ to R₂₈ in Formulae (A) to (D) include, but are not limited to, a 1,1,1-trifluoroethyl group, a 1,1,1,2,2-pentafluoropropyl group, a 1,1,1,2,2,3,3-heptafluorobutyl group, a trifluoromethyl group, and a pentafluoroethyl group, among which a trifluoromethyl group is preferred.

Examples of the cycloalkyl group for R₄ to R₂₈ in Formulae (A) to (D) include, but are not limited to, a cyclobutyl group, a cyclopentyl group, and a cyclohexyl group.

Examples of the organic group represented by Formula (A) include those shown below.

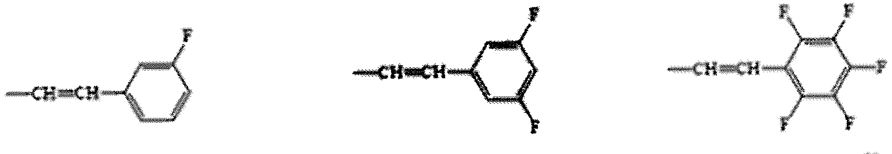

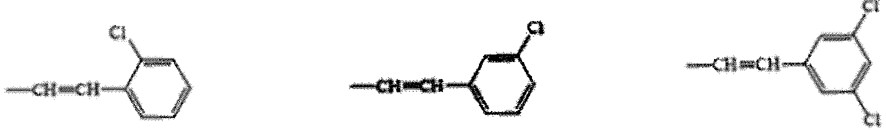

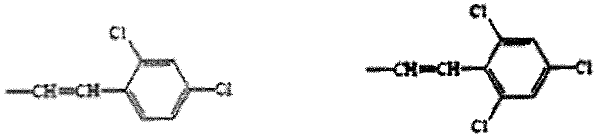

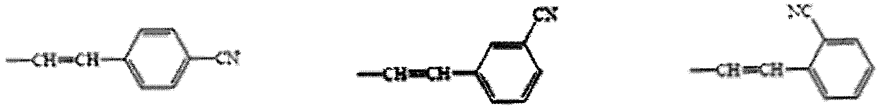

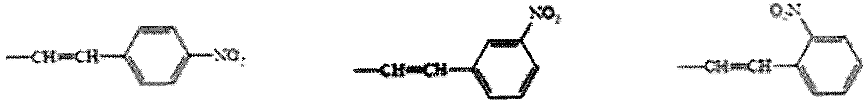

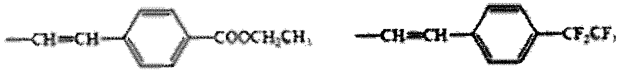

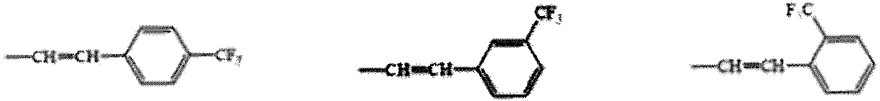

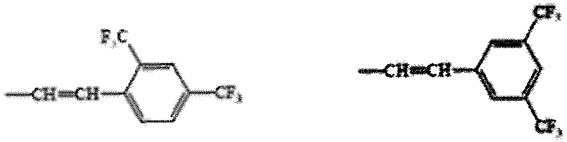

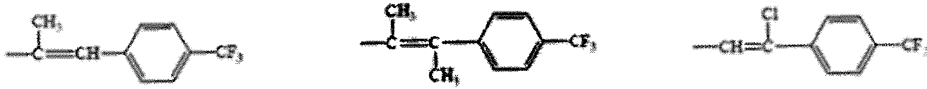

Among them, the organic groups shown below are preferred.

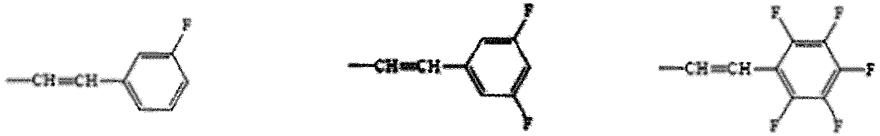

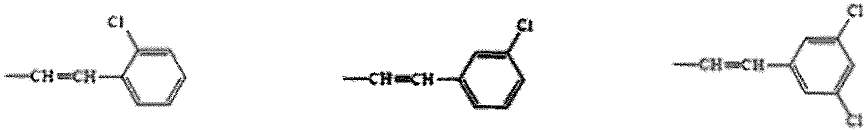

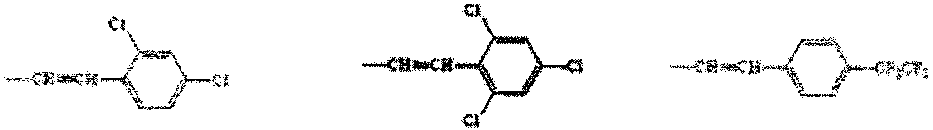

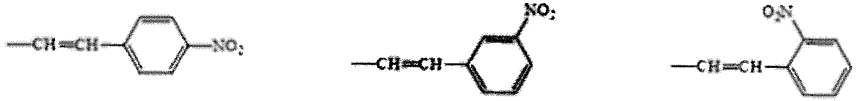

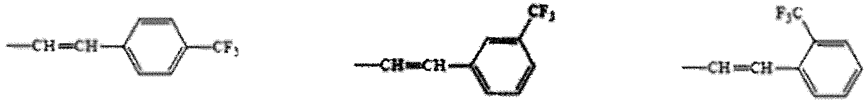

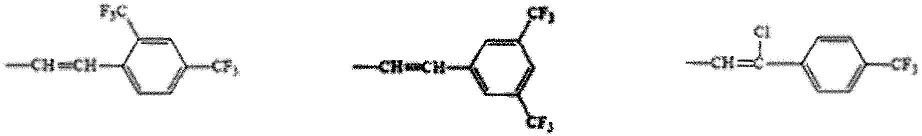

The organic groups shown below are particularly preferred.

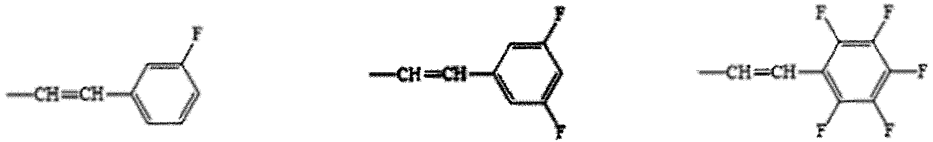

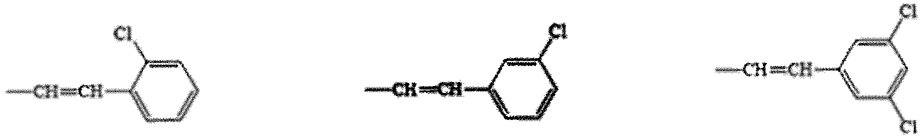

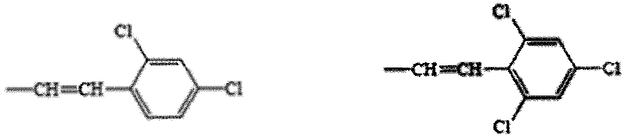

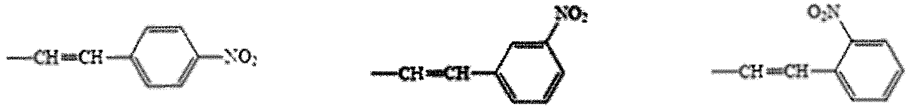

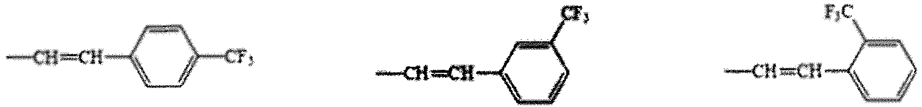

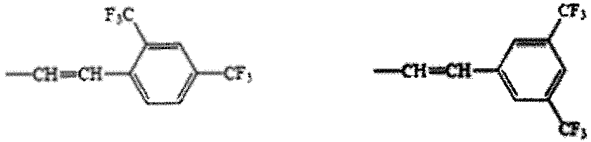

Examples of the organic group represented by Formula (B) include those shown below.

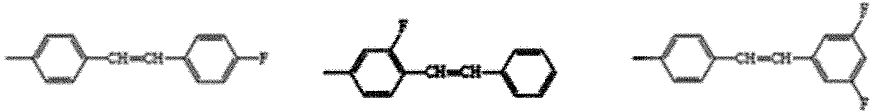

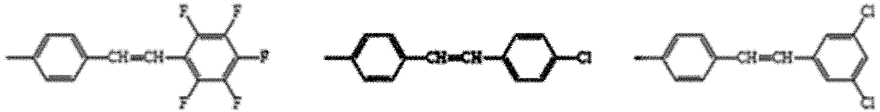

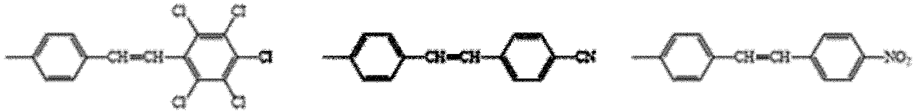

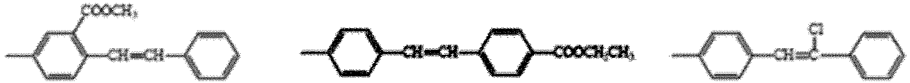

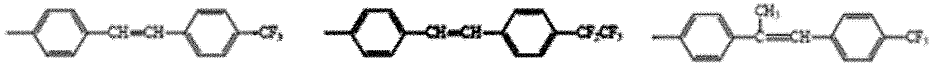

Examples of the organic group represented by Formula (C) include those shown below.

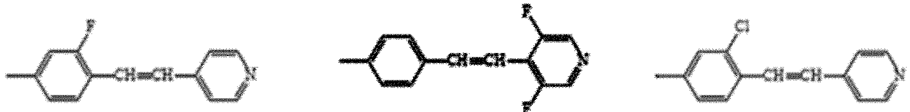

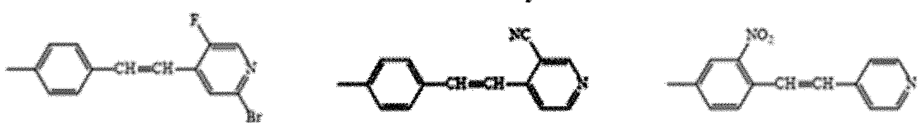

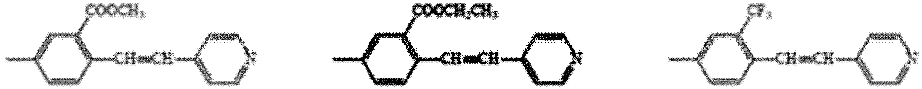

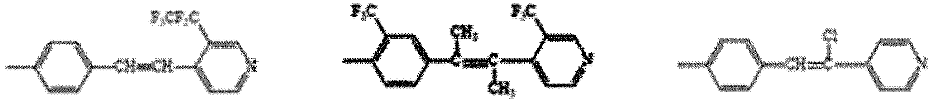

Examples of the organic group represented by Formula (D) include those shown below.

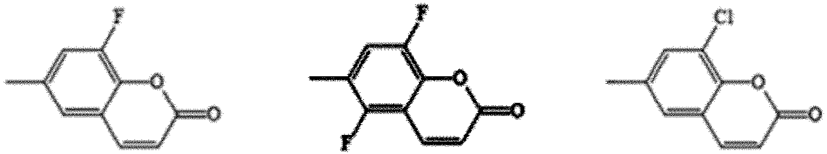

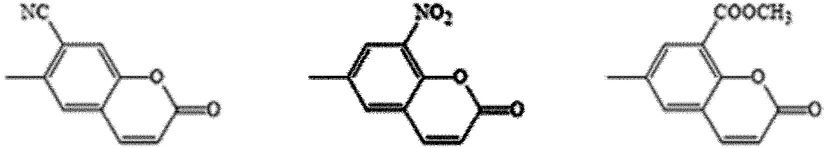

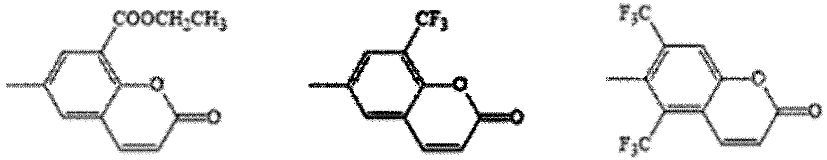

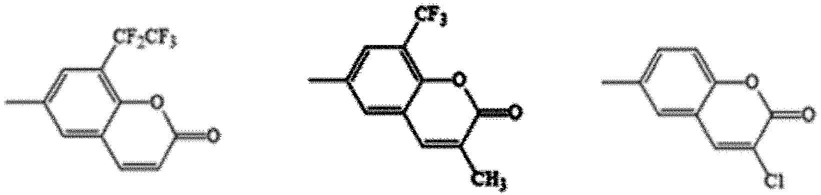

In the resin of the present disclosure, the repeating unit represented by Formula (2) has a HOMO level of -6.4 eV or less, preferably -6.5 eV or less, more preferably -7.00 to - 6.5 eV.

In general, the term "HOMO level" means an orbital energy level of a single molecule. In the description, however, the HOMO level of the repeating unit is defined as the HOMO level of a compound derived from the repeating unit by substituting the ends of the repeating unit with hydrogen atoms.

In the description, the HOMO energy level is the value calculated using the quantum chemical calculation program Gaussian. The calculation conditions include the following: B3LYP (atomic orbital density functional); 6-31G (d, p) (base function); and Gaussian 09W (program used).

For ease of having a HOMO level of -6.4 eV or less, the repeating unit represented by Formula (2) preferably has at least one selected from the group consisting of a halogen atom, a cyano group, a nitro group, a carboxyalkyl group, and a fluoroalkyl group.

The resin of the present disclosure including the repeating units represented by Formulae (1) and (2) contains 20 mol% or more, preferably 40 mol% or more, more preferably 70 mol% or more of the repeating unit represented by Formula (2) based on the total moles of the repeating units represented by Formulae (1) and (2).

In the present disclosure, the molecular weight of the resin including the repeating units represented by Formulae (1) and (2) is typically, but not limited to, 200 to 10,000,000 (g/mole). In view of the viscosity of the resulting resin solution and the mechanical strength of the resin, the molecular weight of the resin is preferably 10,000 to 1,000,000 (g/mole).

The resin including the repeating units represented by Formulae (1) and (2) may have a structure formed by cyclization of a photoreactive group in the polymer molecule as long as the solubility is not impaired.

Examples of the structure formed by cyclization of the photoreactive group includes the structures represented by Formulae (3) to (10) below.

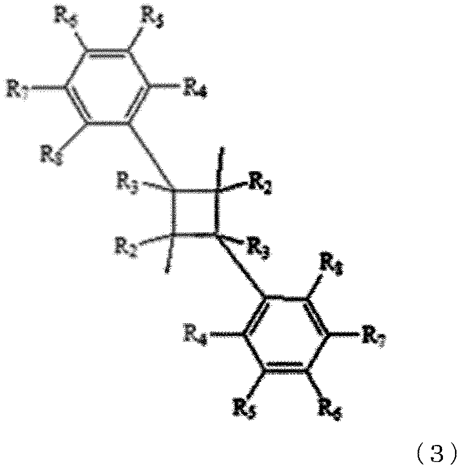

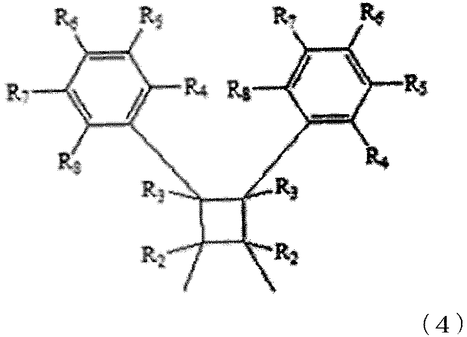

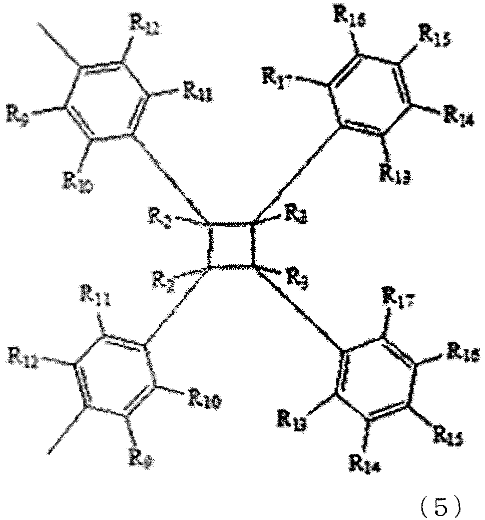

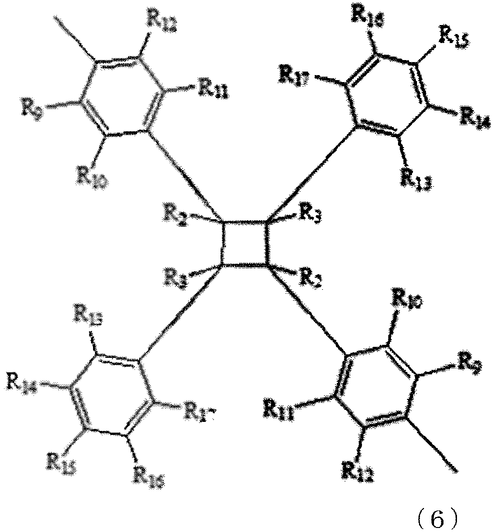

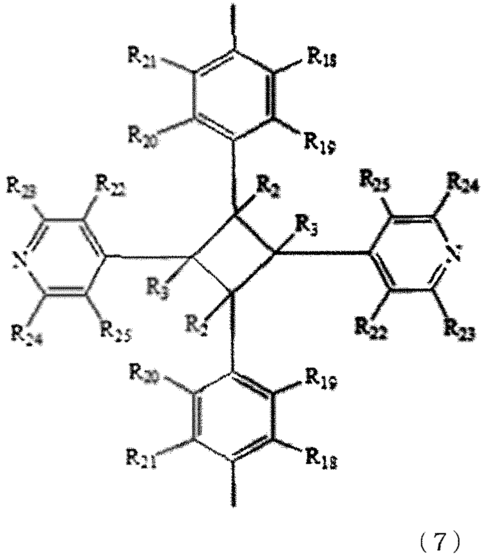

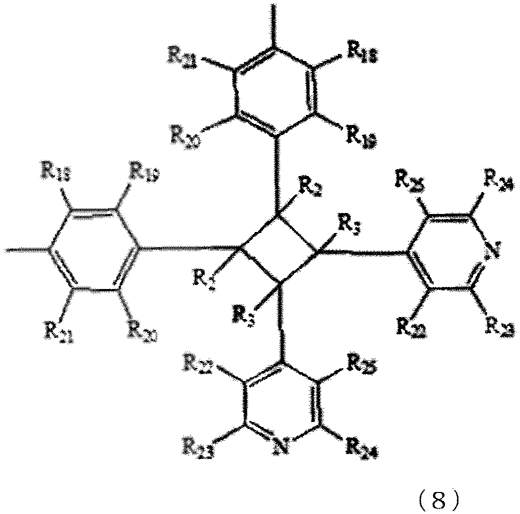

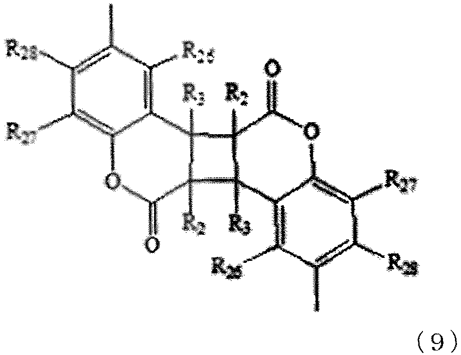

In Formulae (3) to (10), R₂ to R₂₈ are the same as those defined for Formulae (A) to (D).

The resin including the repeating units represented by Formulae (1) and (2) may also contain a structure formed by dimerization of the photoreactive group, such as that shown below.

Examples of the structure formed by dimerization of the photoreactive group includes the structures represented by Formulae (11) to (13) below.

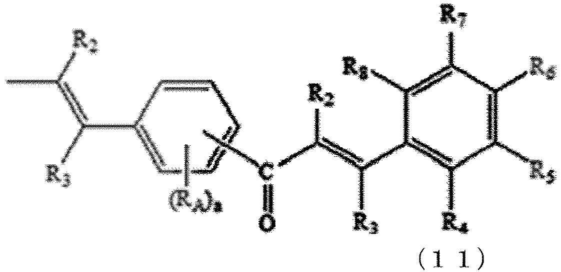

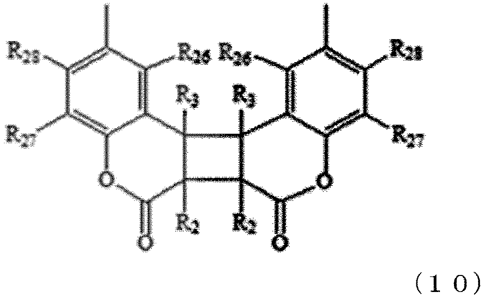

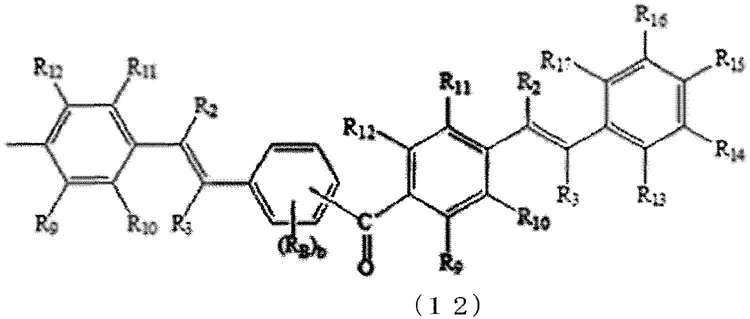

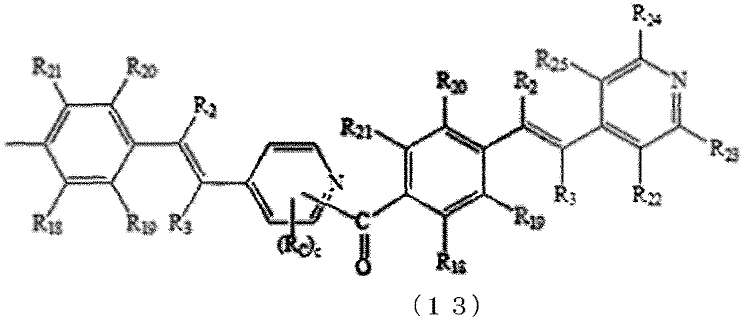

In Formulae (11), (12), and (13), R₂ to R₂₅ are the same as those defined for Formulae (A) to (C), a, b, and c each represent an integer of 0 to 4, R_{A} represents a substituents selected from R₄ to R₈ as defined for Formula (A), R_{B} represents b substituents selected from R₁₃ to R₁₇ as defined for Formula (B), and R_{C} represents c substituents selected from R₂₂ to R₂₅ as defined for Formula (C).

The resin of the present disclosure including the repeating units represented by Formulae (1) and (2) may further include an additional repeating unit other than the repeating units represented by Formulae (1) and (2) as long as the effect of the present disclosure is not impaired. Examples of such an additional repeating unit include butadiene, ethylene, propylene, acrylonitrile, alkyl acrylate, alkyl methacrylate, α-phenylalkyl acrylate, maleic anhydride, acrylic acid, 4-vinylpyridine, trans-1,3-pentadiene, p-acetoxystyrene, vinyltris(trimethoxysiloxy)silane, vinyl benzoate, vinyl butyl ether, and phenyl vinyl ketone, among which ethylene and propylene are preferred.

The resin of the present disclosure including the repeating units represented by Formulae (1) and (2) may be produced by introducing a photocyclizable compound into an aromatic group-containing polymer through a Friedel-Crafts acylation reaction.

In the present disclosure, the photocyclizable compound may be a cinnamic acid chloride compound represented by Formula (14) below, a phenylethenylbenzoic acid chloride compound represented by Formula (15) below, a pyridinylethenylbenzoic acid chloride compound represented by Formula (16) below, or a coumarin-6-carboxylic acid chloride compound represented by Formula (17) below, and is preferably a cinnamic acid chloride compound represented by Formula (14), which is easy to produce. Two or more of these compounds may also be used in combination as needed.

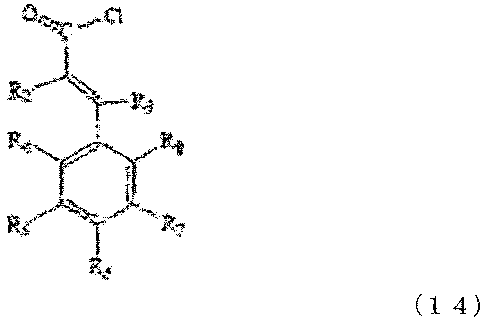

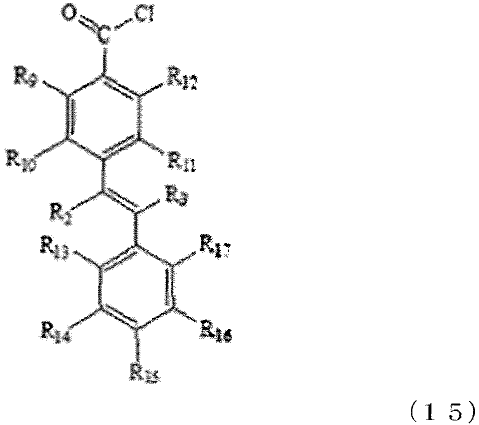

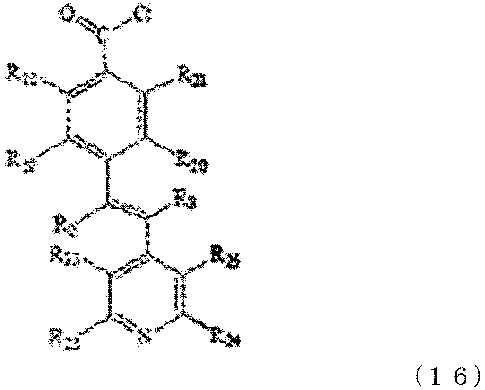

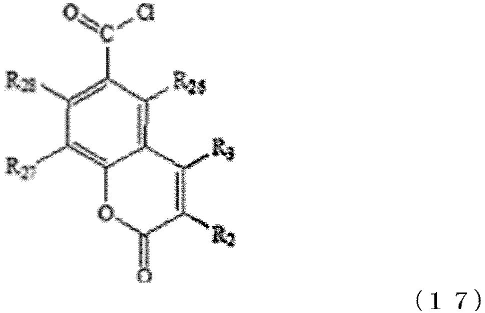

In Formulae (14) to (17), R₂ to R₂₈ are the same as those defined for Formulae (A) to (D).

The aromatic group-containing polymer into which the photoreactive group is to be introduced by the Friedel-Crafts acylation reaction may be any suitable type that is inert to the reaction catalyst described later. Examples of the aromatic group-containing polymer include polystyrenes, such as poly-α-methylstyrene, poly-p-methoxystyrene, and syndiotactic polystyrene; polyvinyl aryl ketones, such as polyvinylnaphthalene, polyvinylbiphenyl, polyvinylanthracene, polyvinylcarbazole, poly(vinyl phenyl ketone); styrenebutadiene copolymers; ethylene-styrene copolymers; ethylenepropylene-styrene copolymers; styrene-acrylonitrile copolymers; styrene-alkyl acrylate copolymers; styrene-alkyl methacrylate copolymers; styrene-α-phenylalkyl acrylate copolymers; styrene-maleic anhydride copolymers; styrene-acrylic acid copolymers; styrene-4-vinylpyridine copolymers; styrene-trans-1,3-pentadiene copolymers; styrene-2,4,6-trimethylstyrene copolymers; styrene-p-acetoxystyrene copolymers; styrene-vinyltris(trimethoxysiloxy)silane copolymers; styrene-vinyl benzoate copolymers; styrene-vinyl butyl ether copolymers; poly(aryl vinyl ketone), such as poly(phenyl vinyl ketone); and petroleum resins. For a reduction in permittivity and a reduction in current leakage, the aromatic group-containing polymer is preferably a polymer made from only an aromatic hydrocarbon(s) and an aliphatic hydrocarbon(s), and examples of such a polymer include polystyrene, ethylene-styrene copolymers, and ethylenepropylene-styrene copolymers. Two or more of these copolymers may also be used in combination.

The amount of the photocyclizable compound charged to the aromatic group-containing polymer into which the photoreactive group is introduced by the Friedel-Crafts acylation reaction is preferably 0.2 to 5.0 mol, more preferably 1.0 to 3.0 mol per mol of aromatic group contained in the aromatic group-containing polymer in order to improve the solubility of the resulting resin in organic solvents and the storage stability. In view of solubility in organic solvents, storage stability, and high photocrosslinkability, and in view of solvent resistance (crack resistance) of the photocrosslinked resin layer, the amount of the photoreactive group to be introduced into the aromatic group by the reaction is preferably 0.2 to 1.0 mole, more preferably 0.4 to 1.0 mole, based on 1 mole of the aromatic group in the resin.

The Friedel-Crafts acylation reaction may be carried out using a reaction catalyst.

In the present disclosure, the reaction catalyst is preferably a known superacid, examples of which include, but are not limited to, trifluoromethanesulfonic acid, fluorosulfonic acid, fluoroantimonic acid, and carborane acid. In order to prevent reaction rate reduction and avoid complicated neutralization process after the reaction, the reaction catalyst is preferably added in an amount of 0.1 to 3.0 moles to 1 mole of the photocyclizable compound.

The Friedel-Crafts acylation reaction, which is exothermic, may be accompanied by a side reaction to thermally crosslink the photoreactive group in the reaction system. In the present disclosure, therefore, for the prevention of such a side reaction, the Friedel-Crafts acylation reaction is preferably carried out by solution reaction, during which the reaction temperature can be easily controlled. In the present disclosure, the solution reaction may be performed using any reaction solvent that is stable against the Friedel-Crafts reaction. The reaction solvent is preferably a sufficiently dehydrated (and thus inactive to the reaction) chlorinated hydrocarbon solvent, fluorinated solvent, aliphatic hydrocarbon solvent, sulfur-containing solvent, or nitrile solvent. Examples of the chlorinated hydrocarbon solvent include methylene chloride, carbon tetrachloride, 1,1,2-trichloroethane, and chloroform. Examples of the fluorinated solvent include ZEORORA H. Examples of the aliphatic hydrocarbon solvent include cyclohexane. Examples of the sulfur-containing solvent include carbon disulfide, sulfone dimethyl sulfoxide, dimethyl sulfate, and dimethyl sulfone. Examples of the nitrile solvent include acetonitrile.

In the Friedel-Crafts acylation reaction, the reaction temperature is preferably, but not limited to, 0 to 40°C in view of economy in cooling and heating. If necessary, the Friedel-Crafts acylation reaction may be carried out at a solvent reflux temperature, and such a temperature is preferably less than 200°C.

In the Friedel-Crafts acylation reaction, the reaction time is typically, but not limited to, 1 to 100 hours. In view of reaction rate and economy, the reaction time is preferably 2 to 20 hours.

The resin of the present disclosure including the repeating units represented by Formulae (1) and (2) may be dissolved in a solvent, and the resulting solution may be applied or printed onto a variety of substrates to form a film.

The solvent may be any type capable of dissolving the resin, examples of which include cyclohexane, aromatic hydrocarbons, such as benzene, toluene, xylene, ethylbenzene, isopropylbenzene, N-hexylbenzene, tetralin, decalin, isopropylbenzene, and chlorobenzene; chlorinated aliphatic hydrocarbon compounds, such as methylene chloride and 1,1,2-trichloroethylene; aliphatic cyclic ether compounds, such as tetrahydrofuran and dioxane; ketone compounds, such as methyl ethyl ketone, cyclopentanone, and cyclohexanone; ester compounds, such as ethyl acetate, dimethyl phthalate, methyl salicylate, amyl acetate, and 2-methoxy-1-methylethyl acetate; alcohols, such as n-butanol, ethanol, and isobutanol; and 1-nitropropane, carbon disulfide, and limonene. If necessary, any mixture of these solvents may be used.

Examples of the substrate include substrates of inorganic materials, such as glass, quartz, aluminum oxide, high-doped silicon, silicon oxide, tantalum dioxide, tantalum pentoxide, and indium tin oxide; plastics; metals, such as gold, copper, chromium, titanium, and aluminum; ceramics; coated paper; and surface-coated nonwoven fabrics. Examples of plastics include polyethylene terephthalate, polyethylene naphthalate, triacetyl cellulose, polycarbonate, polymethyl acrylate, polymethyl methacrylate, polyvinyl chloride, polyethylene, ethylene-vinyl acetate copolymers, polymethylpentene-1, polypropylene, cyclic polyolefin, fluorinated cyclic polyolefin, polystyrene, polyimide, polyvinyl phenol, polyvinyl alcohol, poly(diisopropyl fumarate), poly(diethyl fumarate), poly(diisopropyl maleate), polyether sulfone, polyphenylene sulfide, polyphenylene ether, polyester elastomers, polyurethane elastomers, polyolefin elastomers, polyamide elastomers, and styrene block copolymers.

The resin of the present disclosure may be applied or printed onto the substrate, for example, by spin coating, drop casting, dip coating, doctor blade coating, pad printing, squeegee coating, roll coating, rod bar coating, air knife coating, wire bar coating, flow coating, gravure printing, flexographic printing, screen printing, inkjet printing, or reverse letterpress printing. The film of the present disclosure should be highly soluble in general-purpose solvents for the formation of the film of the present disclosure by these methods.

The resin of the present disclosure including the repeating units represented by Formulae (1) and (2) may be used to form an insulating film. The resulting insulating film may be used as is, or if necessary, may be photocrosslinked (photocyclized) before use. In a case where the insulating film is used as is without being photocrosslinked, the resin should be highly soluble in a general-purpose solvent for use in forming the insulating film, and an organic semiconductor layer should be able to be formed on top of the insulating film using a solvent different from the general-purpose solvent. In this case, the insulating film should have solvent resistance (crack resistance) against the organic semiconductor solution so that the insulating film can be used as is. If the resin does not have excellent solvent resistance (crack resistance), it is not possible to form a film by a printing method, and it is necessary to form a film by a method such as a vapor deposition method, which is less economical than a printing method.

The insulating film including the resin of the present disclosure may be photocrosslinked (photocyclized) using a radiation, such as ultraviolet light with a wavelength of 245 to 350 nm. The irradiation dose is, for example, 50 to 3,000 mJ/cm², preferably 50 to 1,000 mJ/cm² for the prevention of a reduction in cross-linking degree and for the process time reduction for higher economic efficiency, while it may be appropriately changed depending on the composition of the resin. The ultraviolet irradiation is usually performed in air. If necessary, the ultraviolet irradiation may be performed in an inert gas or under an inert gas stream at a constant rate. If necessary, a photosensitizing agent may be added to accelerate the photocrosslinking reaction. The photosensitizing agent may be any type, such as a benzophenone compound, an anthracene compound, an anthraquinone compound, a thioxanthone compound, or a nitrophenyl compound, among which a benzophenone compound is preferred, which have high compatibility with the resin of the present disclosure. Two or more of these sensitizers may be used in combination as needed.

An insulating film containing the crosslinked resin of the present disclosure can be formed and used as a gate insulating layer in an organic field effect transistor device (OFET). The organic field-effect transistor device can be obtained, for example, by stacking, on a substrate, a gate electrode, a gate insulating layer, and an organic semiconductor layer provided with source and drain electrodes with the gate insulating layer interposed between the gate electrode and the semiconductor layer.

The organic field-effect transistor device (OFET) preferably has a mobility of 0.20 cm²/Vs or more in view of its practicality.

In order to be reliable, the organic field-effect transistor device preferably has such a level of bias stress resistance that its threshold voltage will shift only by 2 V or less under application of a bias voltage for 1 hour.

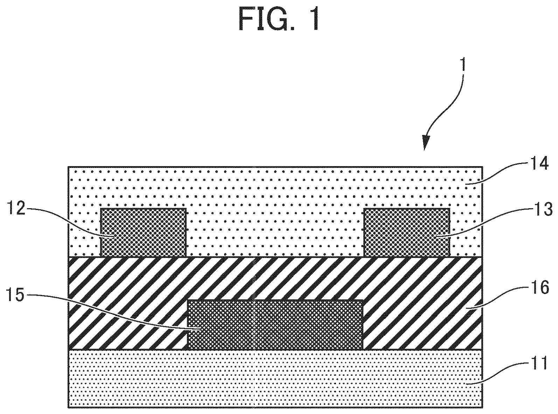

In the present disclosure, the organic field-effect transistor device (OFET) may be any of a bottom-gate bottom-contact (BGBC) type, a bottom-gate top-contact (BGTC) type, a top-gate bottom-contact (TGBC) type, or a top-gate top-contact (TGTC) type. FIG. 1 shows the structure of one of organic field-effect transistor devices of these different structures, specifically the structure of a bottom-gate bottom-contact (BGBC) type device.

The substrate for the OFET may be made of any material that can ensure a sufficiently flat surface for the fabrication of the device. For example, the substrate may be a substrate of an inorganic material, such as glass, quartz, aluminum oxide, high-doped silicon, silicon oxide, tantalum dioxide, tantalum pentoxide, or indium tin oxide; a plastic substrate; a substrate of a metal, such as gold, copper, chromium, titanium, or aluminum; a ceramic substrate; a coated paper sheet; or a surface-coated nonwoven fabric. The substrate may also be a composite material including any combination of these materials or a multilayer material including layers of any of these materials. The surface of these materials may also be coated with a surface-tension modifying material.

Examples of plastics used to form the substrate include polyethylene terephthalate, polyethylene naphthalate, triacetyl cellulose, polycarbonate, polymethyl acrylate, polymethyl methacrylate, polyvinyl chloride, polyethylene, ethylene-vinyl acetate copolymers, polymethylpentene-1, polypropylene, cyclic polyolefin, fluorinated cyclic polyolefin, polystyrene, polyimide, polyvinyl phenol, polyvinyl alcohol, poly(diisopropyl fumarate), poly(diethyl fumarate), poly(diisopropyl maleate), polyether sulfone, polyphenylene sulfide, polyphenylene ether, polyester elastomers, polyurethane elastomers, polyolefin elastomers, polyamide elastomers, and styrene block copolymers. Two or more of these plastic materials may be stacked to form the substrate to be used.

In the present disclosure, the electrically conductive gate, source, or drain electrode may be made of, for example, gold, silver, aluminum, copper, titanium, platinum, chromium, polysilicon, silicide, indium tin oxide (ITO), tin oxide, or any other electrically conductive material. Two or more of these electrically conductive materials may be used to form a multilayer structure.

The BGTC type device may have an electrode formed on the substrate or the organic semiconductor layer. In this case, the electrode may be formed by any suitable method, such as vapor deposition, high-frequency sputtering, or electron beam sputtering. Alternatively, nanoparticles of the electrically conductive material may be dissolved in water or an organic solvent to form an ink, and the electrode may be formed from the ink by solution spin coating, drop casting, dip coating, doctor blade coating, die coating, pad printing, roll coating, gravure printing, flexographic printing, screen printing, inkjet printing, reverse letterpress printing, or any other method. If necessary, a treatment for adsorbing a fluoroalkylthiol or a fluoroarylthiol on the electrode may also be performed.

In the present disclosure, any suitable raw material may be used to form the organic semiconductor layer. The organic semiconductor layer may include either of an N-type organic semiconductor and a P-type organic semiconductor. A combination of an N-type organic semiconductor and a p-type organic semiconductor may also be used to form a bipolar organic field-effect transistor device. Examples of the organic semiconductor include the compounds of Formulae (F-1) to (F-10) below.

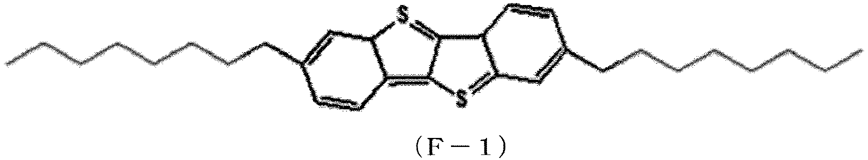

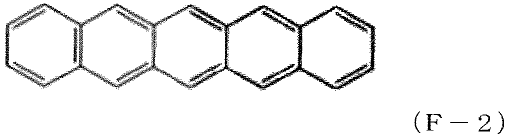

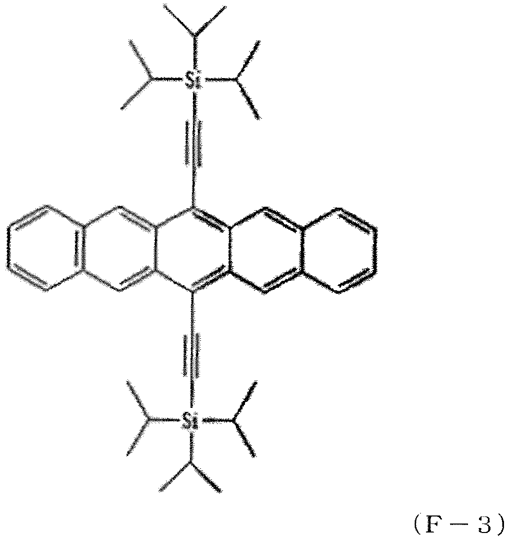

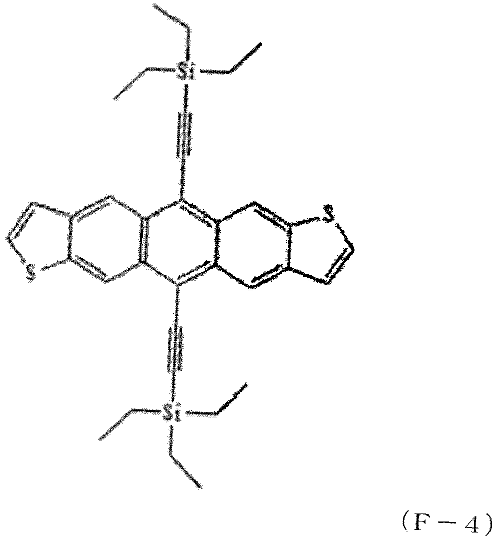

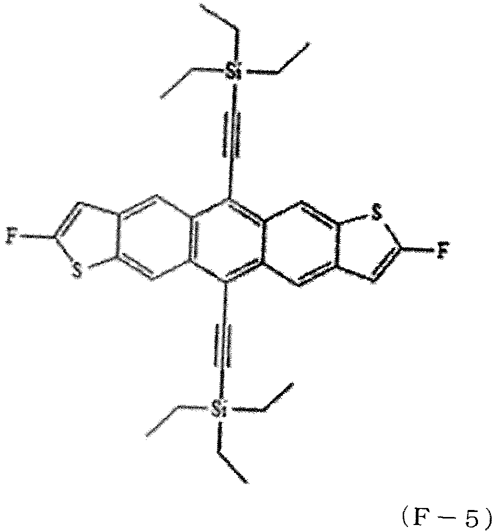

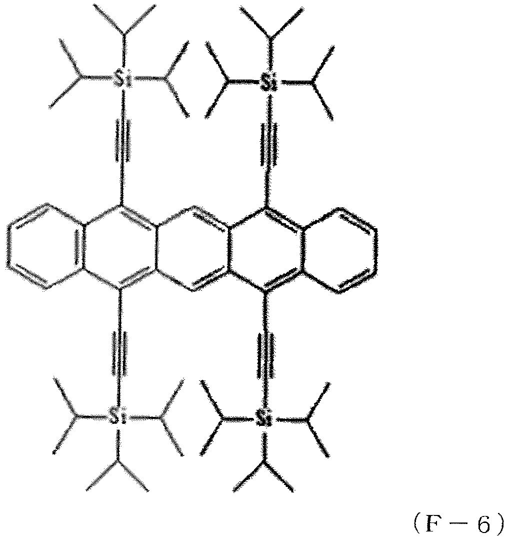

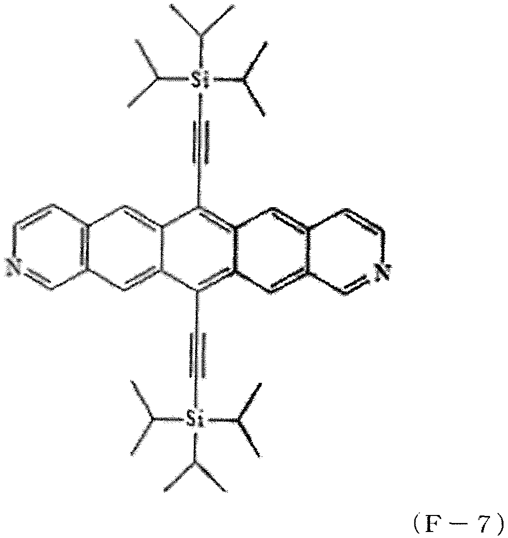

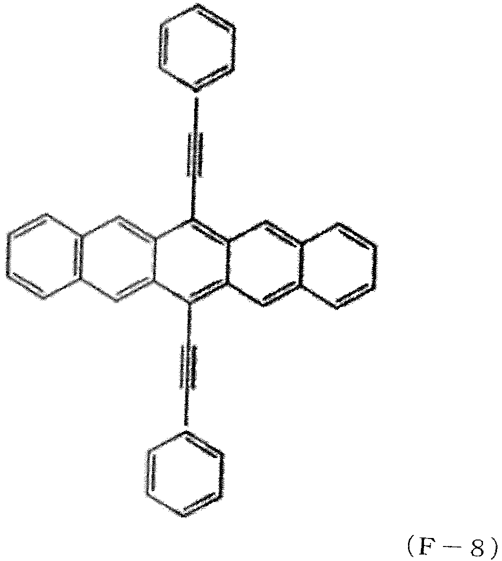

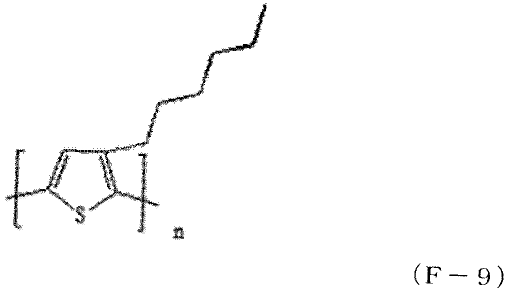

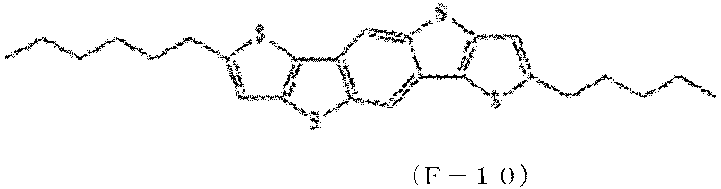

Among the compounds of Formulae (F-1) to (F-10), the compounds of Formulae (F-2), (F-3), and (F-10) are preferred, and the compound of Formula (F-10) is particularly preferred.

In the present disclosure, either of low-molecular-weight and high-molecular-weight organic semiconductors may be used. A mixture of these organic semiconductors may also be used.

In the present disclosure, the organic semiconductor layer may be formed by any suitable method capable of forming a thin film layer of the organic semiconductor, such as a method of vapor-depositing the organic semiconductor under vacuum or a method of applying or printing a solution of the organic semiconductor in an organic solvent. The concentration of the organic semiconductor in the solution to be applied or printed is preferably 0.2 to 5% by weight for the formation of a more uniform semiconductor layer with a reduced thickness while it depends on the structure of the organic semiconductor and the solvent used. The organic solvent may be any type capable of dissolving the organic semiconductor at a certain concentration to enable film formation. Examples of the organic solvent include hexane, heptane, octane, decane, dodecane, tetradecane, decalin, indane, 1-methylnaphthalene, 2-ethylnaphthalene, 1,4-dimethylnaphthalene, a mixture of dimethylnaphthalene isomers, toluene, xylene, ethylbenzene, 1,2,4-trimethylbenzene, mesitylene, isopropylbenzene, pentylbenzene, hexylbenzene, tetralin, octylbenzene, cyclohexylbenzene, 1,2-dichlorobenzene, 1,3-dichlorobenzene, 1,4-dichlorobenzene, trichlorobenzene, 1,2-dimethoxybenzene, 1,3-dimethoxybenzene, γ-butyrolactone, 1,3-butylene glycol, ethylene glycol, benzyl alcohol, glycerin, cyclohexanol acetate, 3-methoxybutyl acetate, ethylene glycol monomethyl ether acetate, ethylene glycol monobutyl ether acetate, propylene glycol monomethyl ether acetate, anisole, cyclohexanone, mesitylene, 3-methoxybutyl acetate, cyclohexanol acetate, dipropylene glycol diacetate, dipropylene glycol methyl ether acetate, diethylene glycol monobutyl ether acetate, diethylene glycol monoethyl ether acetate, 1,6-hexanediol diacetate, 1,3-butylene glycol diacetate, 1,4-butanediol diacetate, ethyl acetate, phenyl acetate, dipropylene glycol dimethyl ether, dipropylene glycol methyl-N-propyl ether, tetradecahydrophenanthrene, 1,2,3,4,5,6,7,8-octahydrophenanthrene, decahydro-2-naphthol, 1,2,3,4-tetrahydro-1-naphthol, α-terpineol, isophorone triacetin decahydro-2-naphthol, dipropylene glycol dimethyl ether, 2,6-dimethylanisole, 1,2-dimethylanisole, 2,3-dimethylanisole, 3,4-dimethylanisole, 1-benzothiophene, 3-methylbenzothiophene, 1,2-dichloroethane, 1,1,2,2-tetrachloroethane, chloroform, dichloromethane, tetrahydrofuran, 1,2-dimethoxyethane, dioxane, cyclohexanone, acetone, methyl ethyl ketone, diethyl ketone, diisopropyl ketone, acetophenone, N,N-dimethylformamide, N-methyl-2-pyrrolidone, and limonene. For the production of a crystalline film with desired properties, an organic solvent having a high organic semiconductor-dissolving power and a boiling point of 100°C or more is appropriate, such as toluene, xylene, isopropylbenzene, anisole, cyclohexanone, mesitylene, 1,2-dichlorobenzene, 3,4-dimethylanisole, pentylbenzene, tetralin, cyclohexylbenzene, or decahydro-2-naphthol. A mixed solvent of two or more of these solvents in an appropriate proportion may also be used.

If necessary, any of various organic or inorganic polymers or oligomers or organic or inorganic nanoparticles may be added in the form of a solid or an organic solvent dispersion to form the organic semiconductor layer. A polymer solution may also be applied onto the gate insulating layer to form a protective film. If necessary, various types of moisture-proof coating or light-resistant coating may also be performed on the protective film.

### EXAMPLES

Hereinafter, the present disclosure will be described in more detail with reference to examples, which are not intended to limit the present disclosure. The organic semiconductor (di-n-hexyldithienobenzodithiophene) used in the examples was synthesized according to the production method disclosed in Japanese Unexamined Patent Application, Publication No. 2015-224238.

In the examples, NMR, spin coating, film thickness measurement, ultraviolet (UV) irradiation, vacuum deposition, and evaluation of the transfer characteristics and bias stress resistance of OFET devices were performed using the conditions and systems shown below.

### NMR

The ¹H-NMR spectrum measurement was performed using JNM-ECZ400S FT-NMR (manufactured by JEOL Ltd.).

### Spin Coating

The spin coater used was MS-A100 manufactured by Mikasa Co., Ltd.

### Film Thickness Measurement

The film thickness was measured using Dektak XT Stylus Profiler manufactured by Bruker Corporation.

### UV Irradiation

The UV irradiation was performed under conditions at a UV dose of 14.2 mW/cm² using UV Mask Aligner UPE-1605MA manufactured by Ushio Lighting, Inc.

### Vacuum Deposition

The vacuum deposition was performed using a compact vacuum deposition system VTR-350M/ERH manufactured by ULVAC Kikou Inc.

### Evaluation of Transfer Characteristics and Bias Stress Resistance

A bottom-gate bottom-contact (BGBC) type organic field-effect transistor device was prepared and measured for transfer characteristics (Id-Vg) before bias voltage application. To evaluate the mobility, the measurement was performed through gate voltage (Vg) scanning using Semiconductor Parameter Analyzer 4200-SCS (manufactured by Keithley Instruments) with a source-drain voltage (Vd) of -15V in the BGBC type FET device. Subsequently, a gate voltage (Vg) of -30 V was continuously applied as a bias voltage for 1 hour to the device, and then the measurement was performed under the same conditions. From the resulting transfer characteristics, the absolute value of the change in threshold voltage before and after the bias voltage application was calculated for evaluation.

Resins 1 to 9 were synthesized as shown below. During the synthesis, the reaction, the purification, and the drying were all performed under yellow light or in the dark. The reason to conduct the synthesis under yellow light or in the dark was to prevent the photocyclization reaction of the photocyclizable compound and to prevent the photocyclization reaction of the resin resulting from the introduction of the photocyclizable compound.

### Example 1

### Synthesis of Resin 1

In a 200 mL Schlenk tube, 8.3 g (38.4 mmol) of 3-(trifluoromethyl)cinnamic acid (manufactured by Tokyo Chemical Industry Co., Ltd.) were weighed. After a reflux tube was attached to the Schlenk tube, the air in the tube was replaced with nitrogen. To the Schlenk tube, a catalytic amount of DMF (manufactured by Fujifilm Wako Pure Chemicals), 33 mL of dichloromethane (manufactured by Fujifilm Wako Pure Chemicals), and 8.3 mL (115 mmol) of thionyl chloride (manufactured by Fujifilm Wako Pure Chemicals) were added in order using a syringe. The mixture was then stirred under reflux at 50°C for 4 hours using a water bath. After the heating was stopped, the reaction mixture was allowed to cool to room temperature. The solvent was then completely removed from the mixture by drying under reduced pressure for 1 hour, so that 3-(trifluoromethyl)cinnamic acid chloride was obtained.

After the synthesis, 2.0 g of polystyrene with a weight average molecular weight of 55,000 (manufactured by DIC Corporation), 27 mL of dichloromethane, and 27 mL of ZEORORA H (manufactured by Zeon Corporation) were added to the Schlenk tube and dissolved with stirring at room temperature. After the solution was sufficiently cooled by placing the Schlenk tube in an ice bath for at least 30 minutes, 8.7 g (38.4 mmol) of trifluoromethanesulfonic acid (manufactured by Fujifilm Wako Pure Chemicals) was added dropwise to the solution using a syringe with stirring. As the dropwise addition proceeded, the color of the polymer solution turned to red purple. After the dropwise addition was completed, the mixture was stirred in ice bath for 1 hour and then allowed to react at room temperature for 5 hours. The solution resulting from the reaction was fed through a cannula to a saturated sodium hydrogen carbonate aqueous solution for neutralization of trifluoromethanesulfonic acid and hydrochloric acid in the system. The aqueous layer of the neutralized solution was removed by decantation, and the dichloromethane layer was separated. The process of adding water to the dichloromethane layer and removing the aqueous layer by decantation was performed twice to remove the excess of sodium hydrogen carbonate. After the decantation, the process of subjecting the solution to reprecipitation with 430 mL of methanol and isolating the resulting polymer by filtration was performed twice, and the product was then dried at 50°C under reduced pressure to give 4.9 g (85% yield) of resin 1.

As a result of ¹H-NMR analysis, the resulting resin 1 (of the formula below) was confirmed to include 21 mol% of the repeating unit represented by Formula (1) and 79 mol% of the repeating unit represented by Formula (2).

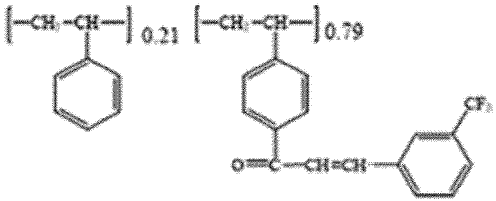

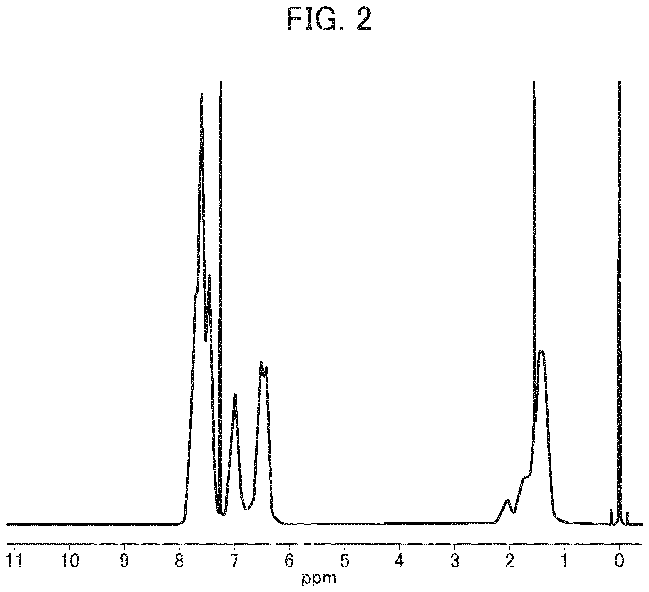

The ¹H-NMR chart of resin 1 is shown in FIG. 2. ¹H-NMR (400 MHz, CDCl₃): δ 7.60 (brs, -CH=CH-Ph), 7.45-6.46 (m, aromatic, -CH=CH-Ph), 2.05 (brs, -CH₂-CH-), 1.73-1.42 (bm, - CH₂-)

### Preparation and Evaluation of FET Device

A 50 nm-thick gate electrode was formed by vacuum deposition of silver on a cleaned, dried glass (substrate) of 30 mm × 30 mm (Eagle XG manufactured by Corning Incorporated). A solution of resin 1 (11 wt%) in 2-methoxy-1-methylethyl acetate was applied onto the electrode-carrying substrate by spin coating under the conditions of 500 rpm for 5 seconds and 2,000 rpm for 20 seconds and then dried at 50°C for 1 minute (to form an insulating film). The resulting film was irradiated with 100 mJ/cm² of ultraviolet rays to form a 500 nm-thick, crosslinked, gate insulating layer. Source and drain electrodes with a thickness of 50 nm, a channel length of 100 µm, and a width of 500 µm were formed by vacuum deposition of gold on the substrate having the gate electrode and the gate insulating layer. Immediately after the deposition, the substrate was immersed in an isopropanol solution of 30 mmol of pentafluorobenzenethiol, removed after 5 minutes from the solution, washed with isopropanol, and dried by blowing air. An organic semiconductor layer was then formed on the substrate by a drop casting process including: dropping 220 µL of a toluene solution of 0.8 wt% of an organic semiconductor (di-n-hexyldithienobenzodithiophene) on the substrate; allowing the drop on the substrate to stand for 15 hours in a dark thermostatic chamber; and heating the drop on the substrate at 40°C for 3 hours to volatilize the solvent. A bottom-gate bottom-contact (BGBC) type organic field-effect transistor device was manufactured by the above method.

Table 1 shows the HOMO level of the repeating unit represented by Formula (2) in the synthesized resin, the mobility of the resulting organic field-effect transistor device, and the result of evaluation of its bias stress resistance.

**[Table 1]**

| | Resin | HOMO level of repeating unit of Formula (2) | Transfer characteristics | Bias stress resistance |
|---|---|---|---|---|
| | | | Mobility | Change in threshold voltage before and after bias stress |
| | | [eV] | [cm²/V·s] | [\|V\|] |
| Example | 1 | -6.62 | 0.23 | 1.0 |
| | 2 | -6.58 | 0.20 | 1.4 |
| | 3 | -6.65 | 0.32 | 0.2 |
| | 4 | -6.85 | 0.32 | 0.2 |
| | 5 | -6.76 | 0.24 | 0.4 |
| | 6 | -6.83 | 0.35 | 1.6 |
| | 7 | -6.43 | 0.21 | 1.8 |
| Comparative Example | 8 | -6.27 | 0.10 | 5.5 |
| | 9 | -6.09 | 0.05 | 4.0 |

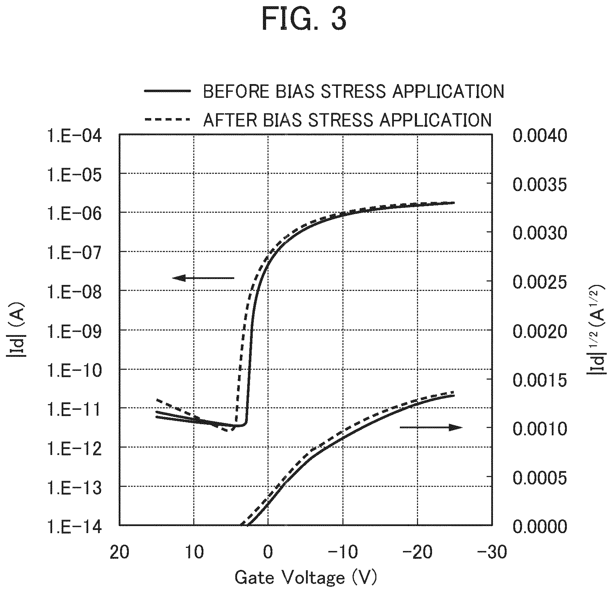

At a source-drain voltage (Vd) of -15 V, gate voltage (Vg) scanning was performed to measure the transfer characteristics (Id-Vg) of the field-effect transistor device before bias voltage application. As a result, the field-effect transistor device showed a high mobility of 0.23 cm²/V·s. Subsequently, a gate voltage (Vg) of -30 V was continuously applied for 1 hour to the field-effect transistor device, and then the measurement was performed under the same conditions. From the resulting transfer characteristics, the change in threshold voltage before and after the bias voltage application was calculated for evaluation. As a result, the change in threshold voltage was 1.0 V, which indicated high bias stress resistance. FIG. 3 shows the transfer characteristics before and after the bias stress application.

### Example 2

Resin 2 was obtained in an amount of 4.3 g (89% yield) in the same manner as in Example 1 except that 3-(trifluoromethyl)cinnamic acid was replaced with 2-(trifluoromethyl)cinnamic acid (manufactured by Tokyo Chemical Industry Co., Ltd.).

As a result of ¹H-NMR analysis, the resulting resin 2 (of the formula below) was confirmed to include 26 mol% of the repeating unit represented by Formula (1) and 74 mol% of the repeating unit represented by Formula (2). 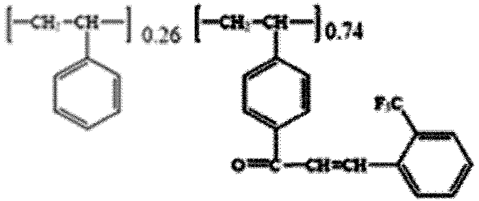 ¹H-NMR (400 MHz, CDCl₃): δ 7.60 (brs, -CH=CH-Ph), 7.99-6.46 (m, aromatic, -CH=CH-Ph), 2.05 (brs, -CH₂-CH-), 1.73-1.42 (bm, - CH₂-)

An insulating film and an organic field-effect transistor device were formed in the same manner as in Example 1 except that the resulting resin 2 was used instead and the UV irradiation dose was changed to 500 mJ/cm². The transfer characteristics were evaluated in the same manner as in the case of resin 1. As a result, the organic field-effect transistor device showed a mobility of 0.20 cm²/V·s, and the change in threshold voltage before and after the bias stress application was 1.4 V, which indicated high mobility and high bias stress resistance. The evaluation results are also shown in Table 1.

### Example 3

Resin 3 was obtained in an amount of 3.8 g (72% yield) in the same manner as in Example 1 except that 3-(trifluoromethyl)cinnamic acid was replaced with 4-(trifluoromethyl)cinnamic acid (Tokyo Chemical Industry Co., Ltd.).

As a result of ¹H-NMR analysis, the resulting resin 3 (of the formula below) was confirmed to include 14 mol% of the repeating unit represented by Formula (1) and 86 mol% of the repeating unit represented by Formula (2). 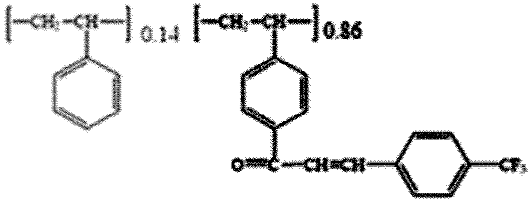 ¹H-NMR (400 MHz, CDCl₃): δ 7.58 (brs, -CH=CH-Ph), 7.54-6.46 (m, aromatic, -CH=CH-Ph), 2.08 (brs, -CH₂-CH-), 1.82-1.45 (bm, - CH₂-)

An insulating film and an organic field-effect transistor were formed in the same manner as in Example 1 except that the resulting resin 3 was used instead. The transfer characteristics were evaluated in the same manner as in the case of resin 1. As a result, the organic field-effect transistor device showed a mobility of 0.32 cm²/V·s, and the change in threshold voltage before and after the bias stress application was 0.2 V, which indicated high mobility and high bias stress resistance. The evaluation results are also shown in Table 1.

### Example 4

Resin 4 was obtained in an amount of 4.0 g (80% yield) in the same manner as in Example 1 except that 3-(trifluoromethyl)cinnamic acid was replaced with trans-3,5-bis(trifluoromethyl)cinnamic acid (manufactured by Apollo Scientific) and that the amount of trifluoromethanesulfonic acid was changed to 7.2 g (48 mmol).

As a result of ¹H-NMR analysis, the resulting resin 4 (of the formula below) was confirmed to include 22 mol% of the repeating unit represented by Formula (1) and 78 mol% of the repeating unit represented by Formula (2). 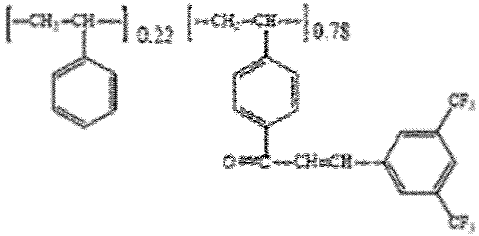 ¹H-NMR (400 MHz, CDCl₃): δ 7.63 (brs, -CH=CH-C(O)-), 8.00-6.48 (m, aromatic, -CH=CH-Ph), 2.05 (brs, -CH₂-CH-), 1.73-1.42 (bm, -CH₂-)

An insulating film and an organic field-effect transistor device were formed in the same manner as in Example 1 except that the resulting resin 4 was used instead and the solution concentration was changed to 12 wt%. The transfer characteristics were evaluated in the same manner as in the case of resin 1. As a result, the organic field-effect transistor device showed a mobility of 0.32 cm²/V·s, and the change in threshold voltage before and after the bias stress application was 0.2 V, which indicated high mobility and high bias stress resistance. The evaluation results are also shown in Table 1.

### Example 5

Resin 5 was obtained in an amount of 3.0 g (53% yield) in the same manner as in Example 1 except that 3-(trifluoromethyl)cinnamic acid was replaced with 2,3,4,5,6-pentafluorocinnamic acid (manufactured by Tokyo Chemical Industry Co., Ltd.).

As a result of ¹H-NMR analysis, the resulting resin 5 (of the formula below) was confirmed to include 13 mol% of the repeating unit represented by Formula (1) and 87 mol% of the repeating unit represented by Formula (2). 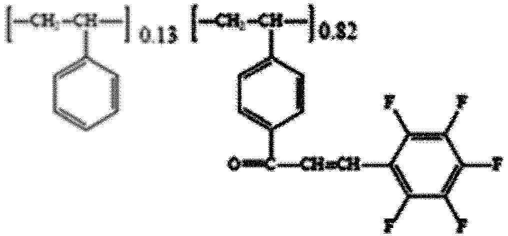 ¹H-NMR (400 MHz, CDCl₃): δ 7.73 (brs, -CH=CH-C(O)-), 7.64-6.50 (m, aromatic, -CH=CH-Ph), 2.01 (brs, -CH₂-CH-), 1.81-1.41 (bm, -CH₂-)

An insulating film and an organic field-effect transistor device were formed in the same manner as in Example 1 except that the resulting resin 5 was used instead and the UV irradiation dose was changed to 200 mJ/cm². The transfer characteristics were evaluated in the same manner as in the case of resin 1. As a result, the organic field-effect transistor device showed a mobility of 0.24 cm²/V·s, and the change in threshold voltage was 0.4 V, which indicated high mobility and high bias stress resistance. The evaluation results are also shown in Table 1.

### Example 6

Resin 6 was obtained in an amount of 4.0 g (80% yield) in the same manner as in Example 1 except that 3-(trifluoromethyl)cinnamic acid was replaced with 3-nitrocinnamic acid (manufactured by Tokyo Chemical Industry Co., Ltd.).

As a result of ¹H-NMR analysis, the resulting resin 6 (of the formula below) was confirmed to include 57 mol% of the repeating unit represented by Formula (1) and 43 mol% of the repeating unit represented by Formula (2). 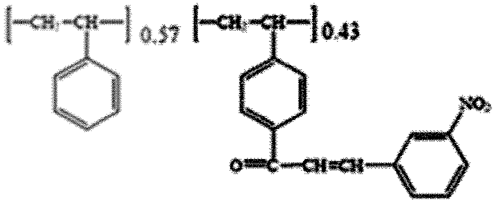 ¹H-NMR (400 MHz, CDCl₃): δ 7.52 (brs, -CH=CH-C(O)-), 8.58-6.60 (m, aromatic, -CH=CH-Ph), 2.15 (brs, -CH₂-CH-), 1.90-1.48 (bm, -CH₂-)

An insulating film and an organic field-effect transistor device were formed in the same manner as in Example 1 except that the resulting resin 6 was used instead. The transfer characteristics were evaluated in the same manner as in the case of resin 1. As a result, the organic field-effect transistor device showed a mobility of 0.35 cm²/V·s, and the change in threshold voltage was 1.6 V, which indicated high mobility and high bias stress resistance. The evaluation results are also shown in Table 1.

### Example 7

Resin 7 was obtained in an amount of 3.7 g (82% yield) in the same manner as in Example 1 except that 3-(trifluoromethyl)cinnamic acid was replaced with 3-fluorocinnamic acid (manufactured by Tokyo Chemical Industry Co., Ltd.).

As a result of ¹H-NMR analysis, the resulting resin 7 (of the formula below) was confirmed to include 23 mol% of the repeating unit represented by Formula (1) and 77 mol% of the repeating unit represented by Formula (2). 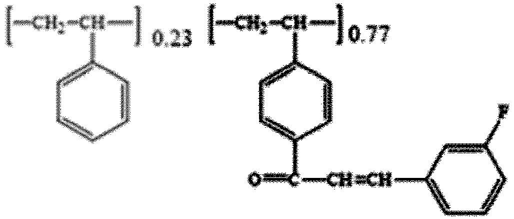 ¹H-NMR (400 MHz, CDCl₃): δ 7.60 (brs, -CH=CH-C(O)-), 7.45-6.50 (m, aromatic, -CH=CH-Ph), 2.05 (brs, -CH₂-CH-), 1.82-1.45 (bm, -CH₂-)

An insulating film and an organic field-effect transistor device were formed in the same manner as in Example 1 except that the resulting resin 7 was used instead. The transfer characteristics were evaluated in the same manner as in the case of resin 1. As a result, the organic field-effect transistor device showed a mobility of 0.21 cm²/V·s, and the change in threshold voltage was 1.8 V, which indicated high mobility and high bias stress resistance. The evaluation results are also shown in Table 1.

### Comparative Example 1

In a glove box, 6.4 g (38.4 mmol) of cinnamic acid chloride (manufactured by Fujifilm Wako Pure Chemicals) and 2.0 g of polystyrene with a weight average molecular weight of 55,000 (manufactured by DIC Corporation) were weighed in a 200 mL Schlenk tube. After the Schlenk tube was taken out of the glove box, 29 mL of dichloromethane was added to the Schlenk tube, and the mixture was dissolved at room temperature with stirring. With stirring, 5.8 g (38.4 mmol) of trifluoromethanesulfonic acid (manufactured by Fujifilm Wako Pure Chemicals) was slowly added dropwise to the solution using a syringe. As the dropwise addition proceeded, the color of the polymer solution turned to red purple. After the dropwise addition was completed, the mixture was allowed to react at room temperature for 4 hours. The solution resulting from the reaction was fed through a cannula to a saturated sodium hydrogen carbonate aqueous solution for neutralization of trifluoromethanesulfonic acid and hydrochloric acid in the system. The aqueous layer of the neutralized solution was removed by decantation, and the dichloromethane layer was separated. The process of adding water to the dichloromethane layer and removing the aqueous layer by decantation was performed twice to remove the excess of sodium hydrogen carbonate. After the decantation, the process of subjecting the solution to reprecipitation with 430 mL of methanol and isolating the resulting polymer by filtration was performed twice, and the product was then dried at 50°C under reduced pressure to give 3.7 g (91% yield) of resin 8.

As a result of ¹H-NMR analysis, the resulting resin 8 (of the formula below) was confirmed to include 17 mol% of the repeating unit represented by Formula (1) and 83 mol% of the repeating unit represented by Formula (2). 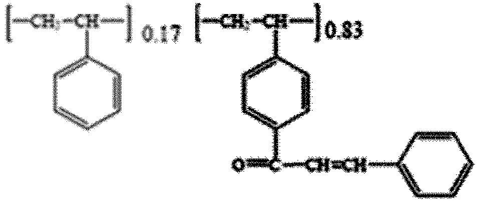 ¹H-NMR (400 MHz, CDCl₃): δ 7.62 (brs, -CH=CH-C(O)-), 7.39-6.51 (m, aromatic, -CH=CH-Ph), 2.04 (brs, -CH₂-CH-), 1.78-1.40 (bm, -CH₂-)

An insulating film and an organic field-effect transistor device were formed in the same manner as in Example 1 except that the resulting resin 8 was used instead. The transfer characteristics were evaluated in the same manner as in the case of resin 1. As a result, the organic field-effect transistor device showed a mobility of 0.10 cm²/V·s, and the change in threshold voltage was 5.5 V, which indicated lower mobility and lower bias stress resistance than Examples 1 to 7. Table 1 shows the features of the prepared organic field-effect transistor device and the evaluation results.

### Comparative Example 2

Resin 9 was obtained in an amount of 4.0 g (70% yield) in the same manner as in Example 1 except that 3-(trifluoromethyl)cinnamic acid was replaced with 4-methylcinnamic acid (manufactured by Tokyo Chemical Industry Co., Ltd.).

As a result of ¹H-NMR analysis, the resulting resin 9 (of the formula below) was confirmed to include 6 mol% of the repeating unit represented by Formula (1) and 94 mol% of the repeating unit represented by Formula (2). 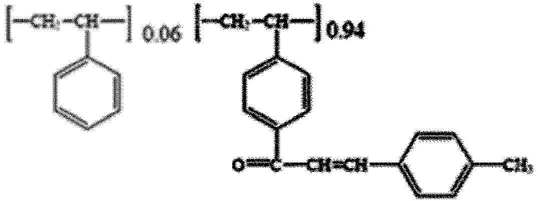 ¹H-NMR (400 MHz, CDCl₃): δ 6.97 (brs, -CH=CH-C(O)-), 7.75-6.43 (m, aromatic, -CH=CH-Ph), 1.38 (brs, -CH₂-CH-), 2.38 (brs, - CH₃)

An insulating film and an organic field-effect transistor device were formed in the same manner as in Example 1 except that the resulting resin 9 was used instead and the UV irradiation dose was changed to 1,000 mJ/cm². The transfer characteristics were evaluated in the same manner as in the case of resin 1. As a result, the organic field-effect transistor device showed a mobility of 0.05 cm²/V·s, and the change in threshold voltage was 4.0 V, which indicated lower mobility and lower bias stress resistance than Examples 1 to 7. Table 1 shows the features of the prepared organic field-effect transistor device and the evaluation results.

The organic field-effect transistor of each of Examples 1 to 7 prepared using the resin including the repeating unit of Formula (2) with a HOMO level of at most -6.4 eV exhibits higher mobility and higher bias stress resistance than that of Comparative Example 1 or 2 prepared using the resin including the repeating unit of Formula (2) with a HOMO level of more than -6.4 eV.

### INDUSTRIAL APPLICABILITY

There is provided a resin suitable for high-quality, organic field-effect transistor devices, which can be manufactured by printed electronics technology.

While the present disclosure has been described in detail with reference to specific embodiments, it will be apparent to a person skilled in the art that the embodiments may be altered or modified in various ways without departing from the scope of the present invention, as defined by the appended claims. The present application is based on a Japanese patent application (Japanese Patent Application No. 2021-175454) filed on October 27, 2021.

### EXPLANATION OF REFERENCE NUMERALS

- 1:: Organic field-effect transistor device
- 11:: Substrate (glass)
- 12:: Source electrode
- 13:: Drain electrode
- 14:: Organic semiconductor layer
- 15:: Gate electrode
- 16:: Gate insulating layer

## Claims

1. A resin comprising: a repeating unit represented by Formula (1); and a repeating unit represented by Formula (2), the repeating unit represented by Formula (2) having a HOMO level of -6.4 eV or less when the HOMO level is determined as indicated in the description, the resin containing 20 mol% or more of the repeating unit represented by Formula (2) based on the total moles of the repeating unit represented by Formula (1) and the repeating unit represented by Formula (2), 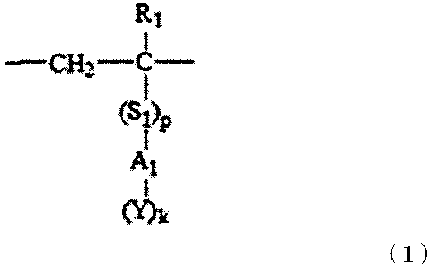
wherein in Formula (1), R₁ represents a hydrogen atom or a C1-C6 alkyl group, S₁ represents **-O-** or -C(O)-, p represents 0 or 1, A₁ represents a C6-C19 aryl group, Y represents a halogen atom, a cyano group, a nitro group, a carboxyalkyl group, an alkyl ether group, an aryl ether group, a C1-C18 alkyl group, a fluoroalkyl group, or a cycloalkyl group, k represents an integer of 0 to (s-1), and s represents the number of carbon atoms in A₁, 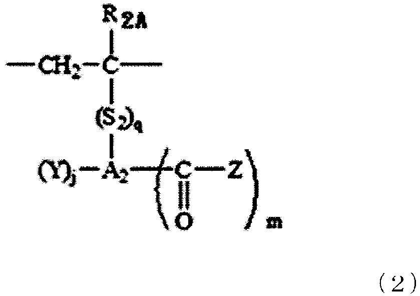
wherein in Formula (2), R_{2A} represents a hydrogen atom or a C1-C6 alkyl group, S₂ represents -O- or -C(O)-, q represents 0 or 1, A₂ represents a C6-C19 aryl group, Y represents the same substituent as defined for Formula (1), j represents an integer of 0 to (r - 2), m represents an integer of 1 to (r - j - 1), r represents the number of carbon atoms in A₂, and Z represents at least one organic group selected from the group consisting of organic groups represented by Formulae (A) to (D) : 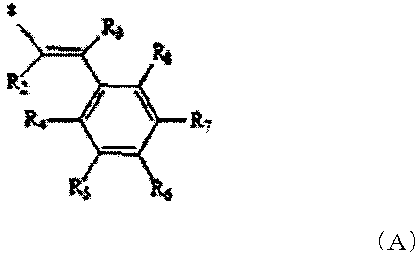 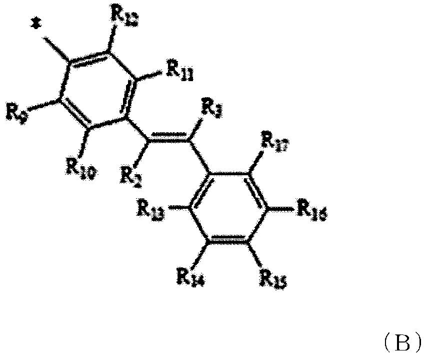 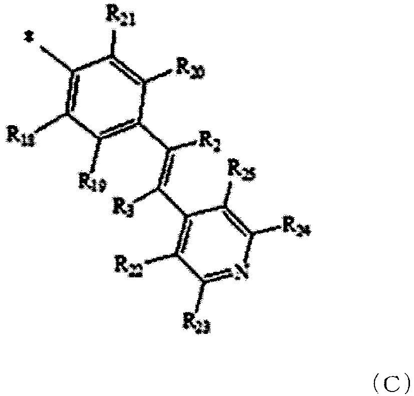 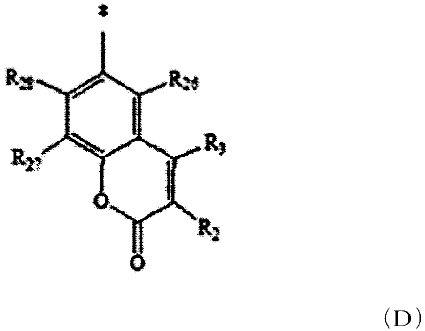
wherein in Formulae (A) to (D), R₂ and R₃ each independently represent a hydrogen atom, a halogen atom, a C1-C6 alkyl group, an aryl group, or a carboxyalkyl group, R₄ to R₂₈ each independently represent a hydrogen atom, a halogen atom, a cyano group, a nitro group, a carboxyalkyl group, an alkyl ether group, an aryl ether group, a C1-C18 alkyl group, a fluoroalkyl group, or a cycloalkyl group, and * indicates a bond,
wherein the repeating unit represented by Formula (2) has at least one selected from the group consisting of a halogen atom, a cyano group, a nitro group, a carboxyalkyl group, and a fluoroalkyl group.

2. An insulating film comprising a crosslinked product of the resin according to claim 1.

3. An organic field effect transistor device (1) comprising (i) an organic semiconductor layer (14), the organic field effect transistor further comprising a source electrode (12) and a drain electrode (13) and (ii) a gate electrode (15) laminated on a substrate (11), with a gate insulating layer (16) interposed between the gate electrode and the organic semiconductor layer, **characterized in that** the gate insulating layer is the insulating film according to claim 2.

## Patentansprüche

1. Harz, umfassend: eine wiederkehrende Einheit, die durch die Formel (1) dargestellt wird; und eine wiederkehrende Einheit, die durch die Formel (2) dargestellt wird, wobei die durch die Formel (2) dargestellte wiederkehrende Einheit ein HOMO-Niveau von -6,4 eV oder weniger aufweist, wenn das HOMO-Niveau wie in der Beschreibung angegeben bestimmt wird, wobei das Harz 20 Mol-% oder mehr der durch die Formel (2) dargestellten wiederkehrenden Einheit bezogen auf die Gesamtmolzahl der durch die Formel (1) dargestellten wiederkehrenden Einheit und der durch die Formel (2) dargestellten wiederkehrenden Einheit enthält, 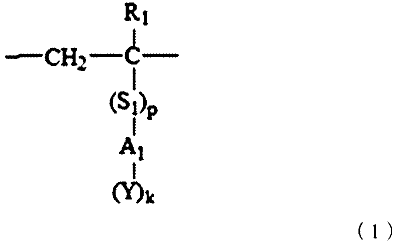
wobei in der Formel (1) R₁ ein Wasserstoffatom oder eine Alkylgruppe mit 1 bis 6 Kohlenstoffatomen darstellt, S₁ -O- oder -C(O)- darstellt, p 0 oder 1 darstellt, A₁ eine Arylgruppe mit 6 bis 19 Kohlenstoffatomen darstellt, Y ein Halogenatom, eine Cyanogruppe, eine Nitrogruppe, eine Carboxyalkylgruppe, eine Alkylethergruppe, eine Arylethergruppe, eine Alkylgruppe mit 1 bis 18 Kohlenstoffatomen, eine Fluoralkylgruppe oder eine Cycloalkylgruppe darstellt, k eine ganze Zahl von 0 bis (s-1) darstellt und s die Anzahl der Kohlenstoffatome in A₁ darstellt, 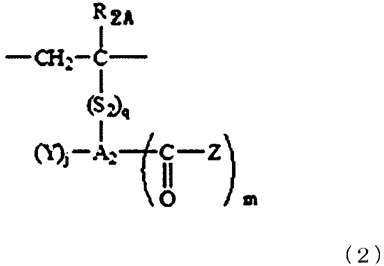
wobei in der Formel (2) R_{2A} ein Wasserstoffatom oder eine Alkylgruppe mit 1 bis 6 Kohlenstoffatomen darstellt, S₂ -O- oder -C(O)- darstellt, q 0 oder 1 darstellt, A₂ eine Arylgruppe mit 6 bis 19 Kohlenstoffatomen darstellt, Y den gleichen Substituenten wie den für die Formel (1) definierten darstellt, j eine ganze Zahl von 0 bis (r - 2) darstellt, m eine ganze Zahl von 1 bis (r - j - 1) darstellt, r die Anzahl der Kohlenstoffatome in A₂ darstellt und Z mindestens eine organische Gruppe darstellt, die aus der Gruppe bestehend aus organischen Gruppen, die durch die Formeln (A) bis (D) dargestellt werden, ausgewählt ist: 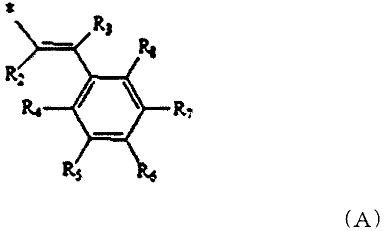 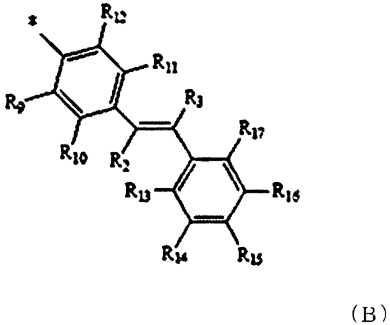 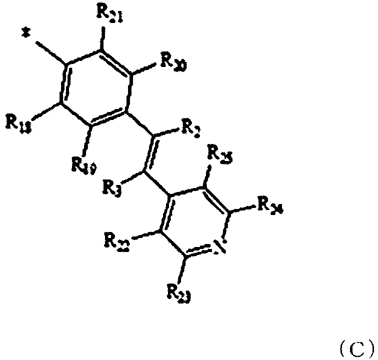 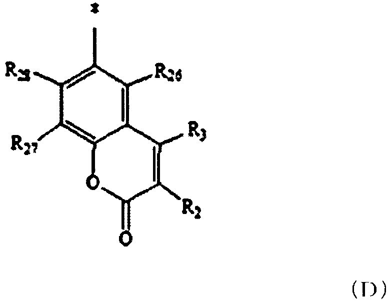
wobei in den Formeln (A) bis (D) R₂ und R₃ jeweils unabhängig voneinander ein Wasserstoffatom, ein Halogenatom, eine Alkylgruppe mit 1 bis 6 Kohlenstoffatomen, eine Arylgruppe oder eine Carboxyalkylgruppe darstellen, R₄ bis R₂₈ jeweils unabhängig voneinander ein Wasserstoffatom, ein Halogenatom, eine Cyanogruppe, eine Nitrogruppe, eine Carboxyalkylgruppe, eine Alkylethergruppe, eine Arylethergruppe, eine Alkylgruppe mit 1 bis 18 Kohlenstoffatomen, eine Fluoralkylgruppe oder eine Cycloalkylgruppe darstellen und * eine Bindung angibt,
wobei die durch die Formel (2) dargestellte wiederkehrende Einheit mindestens eines aufweist, das aus der Gruppe bestehend aus einem Halogenatom, einer Cyanogruppe, einer Nitrogruppe, einer Carboxyalkylgruppe und einer Fluoralkylgruppe ausgewählt ist.

2. Isolierfilm, umfassend ein vernetztes Produkt des Harzes nach Anspruch 1.

3. Organische Feldeffekttransistorvorrichtung (1), umfassend (i) eine organische Halbleiterschicht (14), wobei der organische Feldeffekttransistor ferner eine Sourceelektrode (12) und eine Drainelektrode (13) umfasst, und (ii) eine Gateelektrode (15), die auf einem Substrat (11) laminiert ist, mit einer Gateisolierschicht (16), die zwischen der Gateelektrode und der organischen Halbleiterschicht angeordnet ist,
**dadurch gekennzeichnet, dass** die Gateisolierschicht der Isolierfilm nach Anspruch 2 ist.

## Revendications

1. Résine comprenant : une unité récurrente représentée par la Formule (1) ; et une unité récurrente représentée par la Formule (2), l'unité récurrente représentée par la Formule (2) ayant un niveau HOMO de -6,4 eV ou moins lorsque le niveau HOMO est déterminé comme indiqué dans la description, la résine contenant 20 % en moles ou plus de l'unité récurrente représentée par la Formule (2) sur la base du nombre total de moles de l'unité récurrente représentée par la Formule (1) et de l'unité récurrente représentée par la Formule (2), 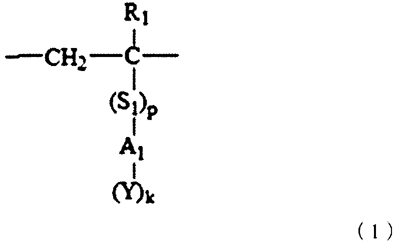
dans laquelle, dans la Formule (1), R₁ représente un atome d'hydrogène ou un groupe alkyle en C1-C6, S₁ représente -O- ou -C(O)-, p représente 0 ou 1, A₁ représente un groupe aryle en C6-C19, Y représente un atome d'halogène, un groupe cyano, un groupe nitro, un groupe carboxyalkyle, un groupe alkyl éther, un groupe aryl éther, un groupe alkyle en C1-C18, un groupe fluoroalkyle ou un groupe cycloalkyle, k représente un nombre entier de 0 à (s-1), et s représente le nombre d'atomes de carbone dans A₁, 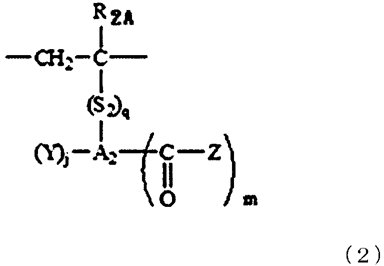
dans laquelle, dans la Formule (2), R_{2A} représente un atome d'hydrogène ou un groupe alkyle en C1-C6, S₂ représente -O- ou -C(O)-, q représente 0 ou 1, A₂ représente un groupe aryle en C6-C19, Y représente le même substituant que celui défini pour la Formule (1), j représente un nombre entier de 0 à (r - 2), m représente un nombre entier de 1 à (r - j - 1), r représente le nombre d'atomes de carbone dans A₂, et Z représente au moins un groupe organique choisi dans le groupe constitué par les groupes organiques représentés par les Formules (A) à (D) : 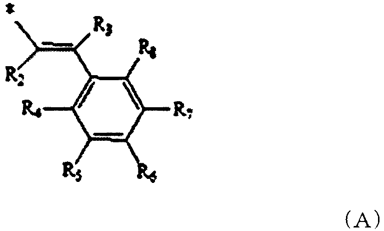 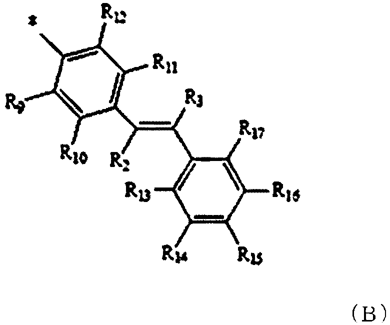 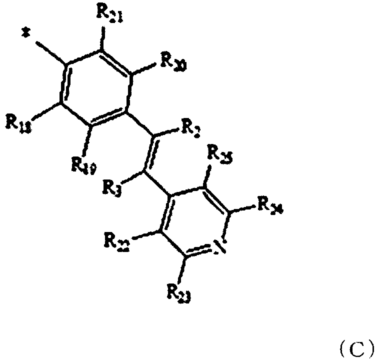 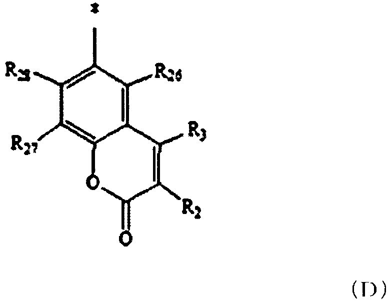
dans lesquelles, dans les Formules (A) à (D), R₂ et R₃ représentent chacun indépendamment un atome d'hydrogène, un atome d'halogène, un groupe alkyle en C1-C6, un groupe aryle ou un groupe carboxyalkyle, R₄ à R₂₈ représentent chacun indépendamment un atome d'hydrogène, un atome d'halogène, un groupe cyano, un groupe nitro, un groupe carboxyalkyle, un groupe alkyl éther, un groupe aryl éther, un groupe alkyle en C1-C18, un groupe fluoroalkyle ou un groupe cycloalkyle, et * indique une liaison,
dans laquelle l'unité récurrente représentée par la Formule (2) a au moins un substituant choisi dans le groupe constitué par un atome d'halogène, un groupe cyano, un groupe nitro, un groupe carboxyalkyle et un groupe fluoroalkyle.

2. Film isolant comprenant un produit réticulé de la résine selon la revendication 1.

3. Dispositif à transistor organique à effet de champ (1) comprenant (i) une couche semi-conductrice organique (14), le transistor organique à effet de champ comprenant en outre une électrode de source (12) et une électrode de drain (13) et (ii) une électrode de grille (15) stratifiée sur un substrat (11), avec une couche isolante de grille (16) intercalée entre l'électrode de grille et la couche semi-conductrice organique,
**caractérisé en ce que** la couche isolante de grille est le film isolant selon la revendication 2.
